(19) Europäisches Patentamt
European Patent Office
Office européen des brevets

(11) EP 4 730 934 A1

(12) EUROPEAN PATENT APPLICATION
published in accordance with Art. 153(4) EPC

(43) Date of publication:
22.04.2026 Bulletin 2026/17

(21) Application number: 24822369.5

(22) Date of filing: 11.04.2024

(51) International Patent Classification (IPC):
H05K 7/20 (2006.01)

(52) Cooperative Patent Classification (CPC):
H05K 7/20

(86) International application number:
PCT/CN2024/087155

(87) International publication number:
WO 2024/255414 (19.12.2024 Gazette 2024/51)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 16.06.2023 CN 202310729682
31.07.2023 CN 202310953724
14.12.2023 CN 202311724720

(71) Applicant: Huawei Technologies Co., Ltd.
Shenzhen, Guangdong 518129 (CN)

(72) Inventors:
• ZHOU, Zhenxin
Shenzhen, Guangdong 518129 (CN)
• SUN, Xiaoguang
Shenzhen, Guangdong 518129 (CN)
• GAO, Junen
Shenzhen, Guangdong 518129 (CN)
• ZHOU, Chen
Shenzhen, Guangdong 518129 (CN)

(74) Representative: Isarpatent
Patent- und Rechtsanwälte PartG mbB
Friedrichstraße 31
80801 München (DE)

(54) **COLD SOURCE INTEGRATION DEVICE, HEAT DISSIPATION SYSTEM, CONTROLLER, AND RELATED METHOD**

(57) An integrated cooling source apparatus, a heat dissipation system, a controller, and a heat dissipation control method relate to the field of heat dissipation technologies. The integrated cooling source apparatus is connected to an air-to-liquid heat exchange mode component through a liquid cooling pipeline and is connected to a liquid-to-liquid heat exchange mode component through the liquid cooling pipeline. The air-to-liquid heat exchange mode component and the liquid-to-liquid heat exchange mode component are connected through the liquid cooling pipeline. The integrated cooling source apparatus is configured to provide a coolant through the liquid cooling pipeline, and the coolant sequentially passes through the air-to-liquid heat exchange mode component configured to dissipate heat for a first component of a device and the liquid-to-liquid heat exchange mode component configured to dissipate heat for a second component of the device. The integrated cooling source apparatus is further configured to receive the coolant that is output after heat is dissipated for the second component. In the apparatus, temperature requirements in different liquid cooling modes are met by supplying a coolant on one path, thereby reducing a quantity of coolant supply routes, a quantity of cooling towers, a quantity of circulating pumps, and a quantity of liquid cooling pipelines, and greatly reducing system complexity.

FIG. 3

## Description

This application claims priorities to Chinese Patent Application No. 202310729682.9, filed with the China National Intellectual Property Administration on June 16, 2023 and entitled "HEAT DISSIPATION SYSTEM", to Chinese Patent Application No. 2023109537247, filed with the China National Intellectual Property Administration on July 31, 2023 and entitled "INTEGRATED COOLING SOURCE APPARATUS, HEAT DISSIPATION SYSTEM, CONTROLLER, AND RELATED METHOD", and to Chinese Patent Application No. 202311724720.8, filed with the China National Intellectual Property Administration on December 14, 2023 and entitled "INTEGRATED COOLING SOURCE APPARATUS, HEAT DISSIPATION SYSTEM, CONTROLLER, AND RELATED METHOD", all of which are incorporated herein by reference in their entireties.

## TECHNICAL FIELD

This application relates to the field of heat dissipation technologies, and in particular, to an integrated cooling source apparatus, a heat dissipation system, a controller, and a heat dissipation control method.

## BACKGROUND

With the advent of the information era, massive data is generated. Data centers (data center, DC) for storing the massive data emerge. The data center is a specific device network that supports collaboration, and is configured to transfer, accelerate, present, compute, and store data on a network infrastructure. As computing power of a chip in the data center grows, power consumption of the chip also continuously increases. How to better use natural cooling sources (such as water and wind) to reduce power consumption and improve component reliability becomes an important issue.

Currently, a full liquid cooling mode is mainly used in the industry to dissipate heat for a device in the data center. A heat dissipation solution for a server in the data center is used as an example for description. The heat dissipation solution for the server includes liquid cooling plate-based heat dissipation and liquid cooling door-based heat dissipation. On a liquid cooling plate-based heat dissipation route, a cooling distribution unit (Cooling Distribution Unit, CDU) or an embedded cooling unit (Embedded Cooling Unit, ECU) is used to transfer heat of a high-heat generation component such as a chip to a primary side (that is, a low-temperature side) of the ECU in a liquid-to-liquid heat exchange mode (which is a mode in which a liquid is used as a heat transfer working medium and flows in an internal flow channel of a liquid cooling plate, to implement cooling through heat transfer), and then a circulating water pump is used to transfer the heat to a closed cooling tower. On a liquid cooling door-based heat dissipation route, a liquid cooling door (a typical example is a water cooling door) is used to transfer heat of a low-heat generation component such as a memory or a hard disk to a primary side of the liquid cooling door in an air-to-liquid heat exchange mode (which is a mode in which hot air generated due to working of a server exchanges heat with a coolant provided by a cooling tower), and then a circulating water pump is used to transfer the heat to a closed cooling tower.

Considering that the liquid cooling plate and the liquid cooling door have different requirements on a water temperature at a water inlet, in the foregoing liquid cooling heat dissipation solution, one water path is usually required to supply water to the CDU, and corresponding components such as the cooling tower and the circulating pump are configured, to implement heat exchange of the liquid cooling plate; and another water path is used to supply water to the liquid cooling door, and correspondingly, corresponding components such as the cooling tower and the circulating pump also need to be configured on the water path, to implement heat exchange of the liquid cooling door. The two water paths each form a circulation loop. In an arrangement process, not only water temperature requirements of the liquid cooling plate and the liquid cooling door need to be considered, but also problems such as component arrangement positions and space occupation on the water paths need to be considered. As a result, arrangement on the entire water paths is complex, and a large quantity of components such as the cooling tower and the circulating pump are required, increasing costs.

## SUMMARY

For the foregoing problem, this application provides an integrated cooling source apparatus, a heat dissipation system, a controller, and a heat dissipation control method, to resolve a problem that costs are increased because pipelines are complex and a relatively large quantity of components such as a cooling tower and a circulating pump are required in an existing liquid cooling heat dissipation solution.

According to a first aspect, this application provides an integrated cooling source apparatus. The integrated cooling source apparatus is connected to an air-to-liquid heat exchange mode component through a liquid cooling pipeline (which is a pipeline for transporting a coolant used for liquid cooling heat dissipation, and usually may be a water cooling pipeline) and is connected to a liquid-to-liquid heat exchange mode component through the liquid cooling pipeline. The air-to-liquid heat exchange mode component and the liquid-to-liquid heat exchange mode component are connected through the liquid cooling pipeline. The air-to-liquid heat exchange mode component is a component that exchanges heat based on hot air generated due to working of a server and a coolant provided by a cooling tower, and includes but is not limited to a liquid cooling door. The liquid-to-liquid heat exchange mode component is a component that uses a liquid as a heat transfer working medium to flow in an internal flow channel of a liquid cooling plate to implement cooling through heat transfer, and includes but is not limited to a liquid cooling plate heat dissipation control unit. The liquid cooling plate heat dissipation control unit may be a cooling distribution unit (Cooling Distribution Unit, CDU) or an embedded cooling unit (Embedded Cooling Unit, ECU).

Specifically, the integrated cooling source apparatus is configured to provide a coolant through the liquid cooling pipeline, and the coolant flows through the air-to-liquid heat exchange mode component configured to dissipate heat for a first component of a device and the liquid-to-liquid heat exchange mode component configured to dissipate heat for a second component of the device. Then, the integrated cooling source apparatus is further configured to receive the coolant that is output after the liquid-to-liquid heat exchange mode component dissipates heat for the second component.

The air-to-liquid heat exchange mode component and the liquid-to-liquid heat exchange mode component have different temperature requirements for the coolant. Generally, a temperature at a liquid inlet of the air-to-liquid heat exchange mode component is lower than a temperature of the liquid-to-liquid heat exchange mode component. Therefore, the coolant first enters the air-to-liquid heat exchange mode component, and the air-to-liquid heat exchange mode component dissipates heat for the first component based on the coolant, so that the heat of the first component can be taken away. In this case, the coolant heats up because the heat of the first component is taken away. The heated coolant can still meet a temperature requirement of the liquid-to-liquid heat exchange mode component, and then may enter the liquid-to-liquid heat exchange mode component. The liquid-to-liquid heat exchange mode component dissipates heat for the second component based on the heated coolant. In this way, the integrated cooling source apparatus can meet requirements of the air-to-liquid heat exchange mode component and the liquid-to-liquid heat exchange mode component by using the coolant on one path, thereby simplifying the liquid cooling pipeline, reducing a quantity of components such as a cooling tower and a circulating pump, and reducing costs. In addition, the foregoing components may be integrally integrated, thereby reducing a floor area, shortening a construction period, and facilitating deployment and maintenance. In addition, the solution reuses the coolant that is output by the air-to-liquid heat exchange mode component, thereby improving power usage effectiveness.

In some possible implementations, the coolant sequentially flows through the air-to-liquid heat exchange mode component configured to dissipate heat for the first component of the device and the liquid-to-liquid heat exchange mode component configured to dissipate heat for the second component of the device.

In some possible implementations, the integrated cooling source apparatus is specifically configured to provide a mixed coolant through the liquid cooling pipeline when a compensatory refrigeration condition is triggered, where a temperature of the mixed coolant meets a temperature requirement of the air-to-liquid heat exchange mode component. The apparatus may use a compensatory refrigeration design based on the mixed coolant (a cooling load is supplemented, so that a temperature of the coolant can meet a requirement). This may further simplify a system architecture and improve system energy efficiency.

In some possible implementations, the integrated cooling source apparatus includes a cooling tower, a circulating pump, a three-way valve, and a compensatory refrigeration chiller, the cooling tower is connected to the circulating pump through a liquid cooling pipeline, the circulating pump is connected to the compensatory refrigeration chiller through a liquid cooling pipeline, and the three-way valve is deployed on the liquid cooling pipeline connecting the circulating pump and the compensatory refrigeration chiller. The integrated cooling source apparatus is specifically configured to adjust a status of the three-way valve to a three-way state when the compensatory refrigeration condition is triggered, so that a coolant provided by the cooling tower is divided into two paths after passing through the circulating pump, and a coolant on one of the two paths is mixed with a coolant on the other path after passing through the compensatory refrigeration chiller, to obtain the mixed coolant.

In this solution, the three-way valve is adjusted to the three-way state, so that after the coolant is shunted, a coolant on one path is mixed with a coolant on the other path after entering the compensatory refrigeration chiller. No independent circulating pump needs to be provided for a compensatory refrigeration route, and the circulating pump is reused, thereby simplifying a system architecture and improving system energy efficiency.

In some possible implementations, the circulating pump includes a primary circulating pump and a secondary circulating pump, and the three-way valve includes a first three-way valve and a second three-way valve. The integrated cooling source apparatus is specifically configured to: when the compensatory refrigeration condition is triggered, adjust a status of the first three-way valve to a three-way state, so that the coolant from the cooling tower is divided into two paths after passing through the primary circulating pump, and a coolant on one of the two paths that passes through a condenser of the compensatory refrigeration chiller and a coolant on the other path that passes through a plate heat exchanger converge before the cooling tower; and adjust a status of the second three-way valve to a three-way state, so that the coolant passing through the plate heat exchanger is divided into two paths after passing through the secondary circulating pump, and a coolant on one of the two paths is mixed with a coolant on the other path after passing through an evaporator of the compensatory refrigeration chiller, to obtain the mixed coolant.

In this solution, the first three-way valve is used to implement reuse of the primary circulating pump, and the second three-way valve is used to implement reuse of the secondary circulating pump, thereby simplifying a system architecture, reducing a quantity of circulating pumps, and reducing costs.

In some possible implementations, the compensatory refrigeration condition includes that a supply liquid temperature is greater than or equal to a preset threshold. The integrated cooling source apparatus further includes a controller, and the controller is configured to: when it is detected that the supply liquid temperature is greater than or equal to the preset threshold, control the status of the three-way valve to be the three-way state, and start the compensatory refrigeration chiller. In this way, on-demand cooling and fine adjustment can be implemented through temperature-based automatic compensatory refrigeration control at a cooling source end.

In some possible implementations, the controller is specifically configured to: determine a bypass flow of the three-way valve based on the supply liquid temperature, a cooling temperature of the compensatory refrigeration chiller, a required temperature of the air-to-liquid heat exchange mode component, and a flow required for heat dissipation, determine a valve opening proportion of the three-way valve based on the bypass flow, and adjust the status of the three-way valve to the three-way state based on the valve opening proportion.

In this solution, the bypass flow of the three-way valve is determined by using the law of conservation of energy, then the valve opening proportion of the three-way valve is determined based on the bypass flow, and the status of the three-way valve is adjusted based on the valve opening proportion, so that a temperature of the mixed coolant can be accurately controlled, thereby meeting a temperature requirement of the air-to-liquid heat exchange mode component.

In some possible implementations, the controller is further configured to: control a supply liquid temperature of the cooling tower based on a wet bulb temperature and an approach of the cooling tower, and then control a secondary-side temperature of the plate heat exchanger based on the supply liquid temperature and an approach of the plate heat exchanger. In this way, the supply liquid temperature of the integrated cooling source apparatus (for example, the secondary-side temperature of the plate heat exchanger) can vary with the wet bulb temperature in an environment. When the wet bulb temperature in the environment decreases, the supply liquid temperature of the integrated cooling source apparatus also decreases accordingly. On an equipment room side, an air exhaust temperature of the air-to-liquid heat exchange mode component decreases, and a temperature in an equipment room decreases.

In some possible implementations, the controller is further configured to control a secondary-side temperature of the plate heat exchanger based on a wet bulb temperature, an approach of the cooling tower, and an approach of the plate heat exchanger. In this solution, the controller directly performs temperature control by using the secondary-side temperature of the plate heat exchanger as an anchor, so that the supply liquid temperature of the integrated cooling source apparatus (for example, the secondary-side temperature of the plate heat exchanger) varies with the wet bulb temperature in an environment.

In some possible implementations, the controller is further configured to: detect that a temperature difference between a liquid outlet of the liquid-to-liquid heat exchange mode component and a liquid inlet of the air-to-liquid heat exchange mode component is less than a specified value, and reduce an opening of an electric valve deployed at the liquid inlet of the air-to-liquid heat exchange mode component. In this way, a flow can be reduced, power consumption of the secondary circulating pump can be reduced, and energy saving control can be implemented.

In some possible implementations, the circulating pump includes the primary circulating pump and the secondary circulating pump, the plate heat exchanger is disposed between the primary circulating pump and the secondary circulating pump, and the controller is further configured to: detect that a temperature difference between a primary-side liquid outlet and a primary-side liquid inlet of the plate heat exchanger is less than a specified value, and control the primary circulating pump to operate at a variable frequency; or detect that a temperature difference between a primary-side liquid outlet and a secondary-side liquid inlet of the plate heat exchanger is less than the approach of the plate heat exchanger, and control the primary circulating pump to operate at a variable frequency. In this way, power consumption of the primary circulating pump can be reduced, and energy saving control can be implemented.

According to a second aspect, this application provides a heat dissipation system. The heat dissipation system includes the integrated cooling source apparatus provided in the first aspect of this application, an air-to-liquid heat exchange mode component, and a liquid-to-liquid heat exchange mode component. The integrated cooling source apparatus is configured to collaborate with the air-to-liquid heat exchange mode component and the liquid-to-liquid heat exchange mode component to dissipate heat for a device.

According to a third aspect, this application provides a heat dissipation control method. The method is applied to an integrated cooling source apparatus, the integrated cooling source apparatus includes a controller, a cooling tower, a circulating pump, a three-way valve, and a compensatory refrigeration chiller, the cooling tower is connected to the circulating pump through a liquid cooling pipeline, the circulating pump is connected to the compensatory refrigeration chiller through a liquid cooling pipeline, the three-way valve is deployed on the liquid cooling pipeline connecting the circulating pump and the compensatory refrigeration chiller, and the method includes:

the controller detects a supply liquid temperature; and

when the supply liquid temperature is greater than or equal to a preset threshold, the controller controls a status of the three-way valve to be a three-way state, and starts the compensatory refrigeration chiller, so that a coolant from the cooling tower is divided into two paths after passing through the circulating pump, and a coolant on one of the two paths is mixed with a coolant on the other path after passing through the compensatory refrigeration chiller, to obtain a mixed coolant.

In some possible implementations, that the controller controls the status of the three-way valve to be the three-way state includes:

the controller determines a bypass flow of the three-way valve based on the supply liquid temperature, a cooling temperature of the compensatory refrigeration chiller, a required temperature of the air-to-liquid heat exchange mode component, and a flow required for heat dissipation; and

the controller determines a valve opening proportion of the three-way valve based on the bypass flow, and adjusts the status of the three-way valve to the three-way state based on the valve opening proportion.

In some possible implementations, the circulating pump includes a primary circulating pump and a secondary circulating pump, a plate heat exchanger is disposed between the primary circulating pump and the secondary circulating pump, and the method further includes:

controlling a supply liquid temperature of the cooling tower based on a wet bulb temperature and an approach of the cooling tower, and then controlling a secondary-side temperature of the plate heat exchanger based on the supply liquid temperature and an approach of the plate heat exchanger; or

controlling a secondary-side temperature of the plate heat exchanger based on a wet bulb temperature, an approach of the cooling tower, and an approach of the plate heat exchanger.

In some possible implementations, the method further includes:
detecting that a temperature difference between a liquid outlet of the liquid-to-liquid heat exchange mode component and a liquid inlet of the air-to-liquid heat exchange mode component is less than a specified value, and reducing an opening of an electric valve deployed at the liquid inlet of the air-to-liquid heat exchange mode component.

In some possible implementations, the circulating pump includes the primary circulating pump and the secondary circulating pump, the plate heat exchanger is disposed between the primary circulating pump and the secondary circulating pump, and the method further includes:

detecting that a temperature difference between a primary-side liquid outlet and a primary-side liquid inlet of the plate heat exchanger is less than a specified value, and controlling the primary circulating pump to operate at a variable frequency; or

detecting that a temperature difference between a primary-side liquid outlet and a secondary-side liquid inlet of the plate heat exchanger is less than the approach of the plate heat exchanger, and controlling the primary circulating pump to operate at a variable frequency.

According to a fourth aspect, this application provides a controller. The controller includes a processor and an input/output unit. The input/output unit is configured to communicate with a three-way valve in an integrated cooling source apparatus. The processor is configured to execute computer-readable instructions, to enable the controller to perform the heat dissipation control method provided in any implementation of the third aspect of this application.

In some possible implementations, the controller further includes a memory, and the processor is specifically configured to:
load the computer-readable instructions from the memory and execute the computer-readable instructions.

In this application, based on implementations according to the foregoing aspects, the implementations may be further combined to provide more implementations.

## BRIEF DESCRIPTION OF DRAWINGS

FIG. 1 is a diagram of an architecture of a data center according to this application;
FIG. 2 is a diagram of a liquid cooling pipeline of an integrated cooling source apparatus according to this application;
FIG. 3 is a diagram of an architecture of another data center according to this application;

FIG. 4 is a diagram of a circulation path of a coolant in an operating state without compensatory refrigeration in an integrated cooling source apparatus or a heat dissipation system according to this application;

FIG. 5 is a diagram of a circulation path of a coolant in an operating state with compensatory refrigeration in an integrated cooling source apparatus or a heat dissipation system according to this application;

FIG. 6 is a diagram of an architecture of another data center according to this application;

FIG. 7 is a diagram of determining a valve opening proportion of a three-way valve according to this application;

FIG. 8 is a diagram of temperature control according to this application;

FIG. 9 is a diagram of performing energy saving control on a circulating pump according to this application; and

FIG. 10 is a flowchart of a heat dissipation control method according to this application.

## DESCRIPTION OF EMBODIMENTS

To resolve a problem that costs are high because pipelines are complex and a plurality of components such as a circulating pump and a cooling tower need to be configured in the foregoing liquid cooling heat dissipation solution, this application provides an integrated cooling source apparatus and a heat dissipation system including the integrated cooling source apparatus. The integrated cooling source apparatus may be an integrated liquid cooling module. The heat dissipation system may include the integrated cooling source apparatus, an air-to-liquid heat exchange mode component (or referred to as an air-to-liquid heat exchange apparatus), and a liquid-to-liquid heat exchange mode component (or referred to as a liquid-to-liquid heat exchange apparatus). The integrated cooling source apparatus is connected to the air-to-liquid heat exchange mode component through a liquid cooling pipeline, and is connected to the liquid-to-liquid heat exchange mode component (for example, a liquid cooling plate heat dissipation control unit like an ECU or a CDU) through the liquid cooling pipeline. The air-to-liquid heat exchange mode component and the liquid-to-liquid heat exchange mode component are connected through the liquid cooling pipeline. The integrated cooling source apparatus is configured to provide a coolant through the liquid cooling pipeline, and the coolant sequentially passes through the air-to-liquid heat exchange mode component configured to dissipate heat for a first component of a device and the liquid-to-liquid heat exchange mode component configured to dissipate heat for a second component of the device. Then, the integrated cooling source apparatus receives the coolant that is output after heat is dissipated for the second component.

The air cooling heat exchange mode component and the liquid-to-liquid heat exchange mode component have different temperature requirements on the coolant. Generally, a temperature at a liquid inlet of the air cooling heat exchange mode component (for example, a liquid cooling door) is lower than a temperature of the liquid-to-liquid heat exchange mode component (for example, a liquid cooling plate heat dissipation control unit like an ECU or a CDU). Therefore, the coolant first enters the air cooling heat exchange mode component, and the air cooling heat exchange mode component dissipates heat for the first component based on the coolant, so that the heat of the first component can be taken away. In this case, the coolant heats up because the heat of the first component is taken away. The heated coolant can still meet a temperature requirement of the liquid-to-liquid heat exchange mode component, and then may enter the liquid-to-liquid heat exchange mode component. The liquid-to-liquid heat exchange mode component dissipates heat for the second component based on the heated coolant. In this way, the integrated cooling source apparatus can meet requirements of the air cooling heat exchange mode component and the liquid-to-liquid heat exchange mode component by using the coolant on one path, thereby simplifying the liquid cooling pipeline, reducing a quantity of components such as a cooling tower and a circulating pump, and reducing costs. In addition, the foregoing components may be integrally integrated, thereby reducing a floor area, shortening a construction period, and facilitating deployment and maintenance.

For ease of understanding, technical terms in this application are first described.

**Liquid cooling (liquid cooling):** is a technology that uses a liquid as a heat transfer medium to exchange heat for a heat generation component in a computing system (for example, a server in a data center), and transfer the heat to the outside of the heat generation component. The liquid cooling technology supports a plurality of heat dissipation modes, including but not limited to a liquid-to-liquid heat exchange (for example, water-to-water heat exchange) mode and an air-to-liquid heat exchange mode. Generally, a liquid-to-liquid heat exchange mode component includes a liquid cooling plate heat dissipation control unit. On a liquid cooling plate-based heat dissipation route, a liquid-to-liquid heat exchange mode component such as a cooling distribution unit (Cooling Distribution Unit, CDU) or an embedded cooling unit (Embedded Cooling Unit, ECU) is used to dissipate heat for a component that generates high heat, for example, a central processing unit (central processing unit, CPU), in the liquid-to-liquid heat exchange mode. An air-to-liquid heat exchange mode component includes a component such as a liquid cooling door inside a cabinet or an air cooling end component such as an in-row air conditioner outside the cabinet, to implement heat exchange between hot air generated by a server and a coolant. For example, on a liquid cooling door-based heat dissipation route, a liquid cooling door is used to dissipate heat for a component that generates low heat, for example, a memory or a hard disk, in the air-to-liquid heat exchange mode. Alternatively, when the air-to-liquid heat exchange mode component is an in-row air conditioner, air-to-liquid heat exchange may be implemented by using the in-row air conditioner. For ease of description, the following embodiments are described by using an example in which the liquid-to-liquid heat exchange mode component is a liquid cooling plate heat dissipation control unit and the air-to-liquid heat exchange mode component is a liquid cooling door.

**Cooling distribution unit CDU:** is a control unit that is located inside an equipment room of a data center and that performs liquid cooling, and is configured to adjust a cooling capacity of a group of cabinets, a temperature and a flow rate of a coolant, and the like.

**Embedded cooling unit ECU:** is built in a cabinet through pre-integration, is a component of the cabinet, and is configured to control a cooling capacity of the cabinet, a temperature and a flow rate of a coolant, and the like.

The following describes in detail principles of a liquid cooling door-based heat dissipation route and a liquid cooling plate-based heat dissipation route with reference to the accompanying drawings.

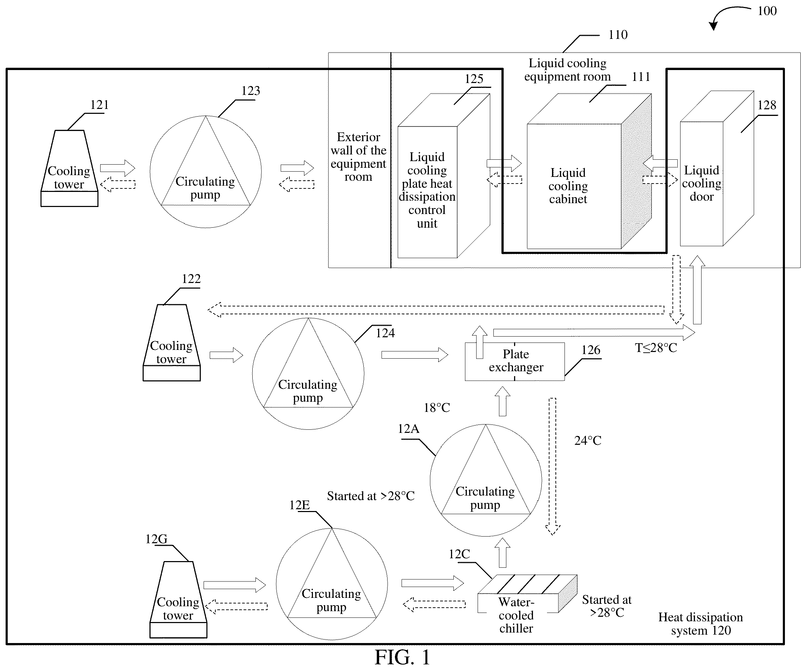

FIG. 1 is a diagram of an architecture of a data center according to this application. In this application, an example in which heat dissipation is performed on a cabinet included in the data center in a liquid cooling heat dissipation manner is used for description. As shown in FIG. 1, the data center 100 includes a liquid cooling equipment room 110 and a heat dissipation system 120.

The liquid cooling equipment room 110 includes a plurality of liquid cooling cabinets 111. The liquid cooling cabinet 111 is an entity that provides high-performance computing, and dissipates heat for a server in the cabinet in a liquid cooling heat dissipation manner. For example, the liquid cooling cabinet 111 includes a plurality of server nodes. The server node may be an independent physical device.

The heat dissipation system 120 includes one or more heat dissipation subsystems, and each heat dissipation subsystem is configured to dissipate heat for the liquid cooling cabinet 111. To improve heat dissipation efficiency, when there are a plurality of heat dissipation subsystems in the heat dissipation system 120, different heat dissipation subsystems may dissipate heat for the liquid cooling cabinet 111 through different heat dissipation routes. For example, a liquid cooling plate heat dissipation subsystem may dissipate heat for the liquid cooling cabinet 111 through a liquid cooling plate-based heat dissipation route, and a liquid cooling door heat dissipation subsystem may dissipate heat for the liquid cooling cabinet through a liquid cooling door-based heat dissipation route.

The liquid cooling plate heat dissipation subsystem includes a cooling tower 121, a circulating pump 123 (for example, a circulating water pump, water pump for short), and a liquid cooling plate heat dissipation control unit 125 (for example, a CDU). The cooling tower 121 is configured to use a liquid cooling working medium (for example, water) as a circulating cooling medium (a coolant), to discharge heat to the atmosphere to reduce a temperature. The circulating pump 123 is configured to provide power for transporting the coolant, for example, is applicable to transporting water or a liquid cooling working medium with physicochemical properties in a high-pressure operation system. The cooling tower 121 may supply a coolant with a relatively low temperature, for example, cold water. The circulating pump 123 transports the coolant to a CDU in the equipment room. The CDU controls a cooling capacity of the liquid cooling cabinet 111, and a temperature and a flow rate of the coolant, to reduce a temperature for the server node in the liquid cooling cabinet 111. The coolant may take away heat of the liquid cooling cabinet 111, and return to the cooling tower 121 through the CDU and the circulating pump 123, and the cooling tower 121 performs heat exchange.

The liquid cooling door heat dissipation subsystem includes a cooling tower 122, a circulating pump 124, a plate heat exchanger 126 (plate exchanger for short), and a liquid cooling door 128. The plate heat exchanger 126 is a new high-efficiency heat exchanger formed by stacking metal plates with a specific corrugated shape. The plate heat exchanger 126 includes a gasket, a pressing plate (a movable end plate and a fastened end plate), and a frame (upper and lower guide rods and a front pillar). A sealing gasket is used to seal the plates and guide a flow to separate a cold flow channel and a hot flow channel. A cold heat exchange medium and a hot heat exchange medium flow through respective channels and exchange heat with the separated plates, to reach a temperature required by a user. The cooling tower 122 may supply a coolant with a relatively low temperature, for example, cold water, and the circulating pump 124 transports the coolant to the plate heat exchanger 126. When a temperature of a coolant separated by the plate heat exchanger 126 is less than 28°C, the coolant may be transported to the liquid cooling door 128 to reduce a temperature for the server in the liquid cooling cabinet 111. The coolant may take away heat of the liquid cooling cabinet 111, and return to the cooling tower 122, and the cooling tower 122 performs heat exchange.

Compared with the liquid cooling plate heat dissipation subsystem, the liquid cooling door heat dissipation subsystem has a higher requirement on the temperature of the coolant. When an ambient temperature is relatively high, the liquid cooling door heat dissipation subsystem usually further needs to supplement a cooling load (compensatory refrigeration for short), so that the coolant meets a temperature requirement of the liquid cooling door heat dissipation subsystem. Specifically, the liquid cooling plate heat dissipation subsystem further includes a circulating pump 12A, a water-cooled chiller 12C, a circulating pump 12E, and a cooling tower 12G. Specifically, when the temperature of the coolant separated by the plate heat exchanger 126 is greater than 28°C, the circulating pump 12A and the water-cooled chiller 12C (which is usually a large-scale unit) are started, and are configured to perform compensatory refrigeration for the coolant separated by the plate heat exchanger 126, so that after the temperature of the coolant is less than 28°C, the coolant is transported to the liquid cooling door 128. In addition, a coolant (such as cold water) used by the water-cooled chiller 12C for compensatory refrigeration may be provided by the cooling tower 12G. The cooling tower 12G may be an open cooling tower. The cooling tower 12G transports the coolant to the water-cooled chiller 12C through the circulating pump 12E, and the water-cooled chiller 12 may further cool, by using a cooling system, the coolant transported by the cooling tower, to provide a coolant whose temperature is 18°C. The water-cooled chiller 12C may take away heat after performing compensatory refrigeration by using the coolant whose temperature is 18°C, and the coolant returns to the cooling tower 12G through the circulating pump 12E. The cooling tower 12G performs heat exchange.

It should be noted that components such as a cooling tower that provides a coolant and a circulating pump that transports the coolant for the liquid cooling plate heat dissipation control unit 125 and the liquid cooling door 128 may be reused, and components such as the cooling tower and the circulating pump may be integrally integrated to form the integrated cooling source apparatus.

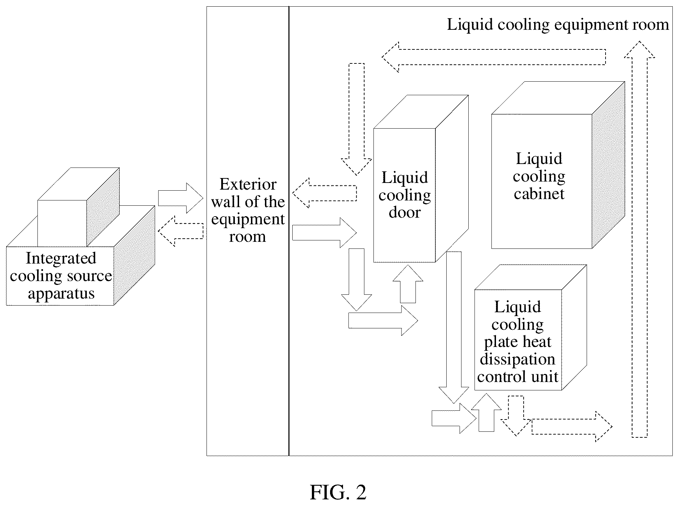

FIG. 2 is a diagram of a liquid cooling pipeline of an integrated cooling source apparatus according to this application. As shown in FIG. 2, the integrated cooling source apparatus is configured to provide a coolant through the liquid cooling pipeline. The coolant may sequentially pass through a liquid cooling door configured to dissipate heat for a first component of a device (for example, a low-heat generation component of a server in a data center, including but not limited to a memory or a hard disk) and a liquid cooling plate control unit configured to dissipate heat for a second component of the device (for example, a high-heat generation component of the server in the data center, including but not limited to a CPU). The integrated cooling source apparatus is further configured to receive the coolant that is output after the liquid cooling plate heat dissipation control unit dissipates heat for the second component.

In FIG. 1 and FIG. 2, an example in which an air-to-liquid heat exchange mode component is a liquid cooling door and a liquid-to-liquid heat exchange mode component is a liquid cooling plate heat dissipation control unit is used for description. A heat dissipation component such as the liquid cooling door may be usually disposed inside a liquid cooling cabinet (an interior of a cabinet in which a server that uses liquid cooling heat dissipation is located, cabinet interior for short). In FIG. 1 and FIG. 2, to facilitate display of a flow direction of a coolant, the liquid cooling door is placed outside the liquid cooling cabinet. When the air-to-liquid heat exchange mode component is an in-row air conditioner, the in-row air conditioner may be disposed outside a cabinet. The in-row air conditioner may perform air-to-liquid heat exchange by row on cabinets arranged in an equipment room by row, to implement in-row cooling. In some examples, the air-to-liquid heat exchange mode component may alternatively be an in-room air conditioner. The in-room air conditioner is usually disposed outside a cabinet, and performs air-to-liquid heat exchange on a plurality of cabinets in an equipment room, to implement in-room cooling.

In this technical solution, the coolant provided on one water path meets requirements of both the liquid cooling door and the liquid cooling plate heat dissipation control unit. For example, the integrated cooling source apparatus provides a coolant on one path. The coolant first enters the liquid cooling door to dissipate heat for the first component of the device. The coolant that is output from the liquid cooling door carries heat and therefore heats up. Because a temperature at a liquid inlet of the liquid cooling door is lower than a temperature at a liquid inlet of the liquid cooling plate, the heated coolant can still meet a temperature requirement of the liquid cooling plate heat dissipation control unit. Therefore, the heated coolant may then enter the liquid cooling plate heat dissipation control unit such as an ECU to dissipate heat for the second component of the device. The coolant that is output after the liquid cooling plate heat dissipation control unit dissipates heat for the second component returns to the integrated cooling source apparatus for heat exchange. In this technical solution, a quantity of coolant supply routes, a quantity of cooling towers, a quantity of circulating pumps, and a quantity of liquid cooling pipelines can be reduced, thereby reducing costs. In addition, this solution can greatly reduce system complexity, facilitate deployment and maintenance, and shorten a construction period. In addition, in this technical solution, the coolant output by the liquid cooling door is reused, so that power usage effectiveness (Power Usage Effectiveness, PUE) is improved, and a service requirement can be met.

Further, in this technical solution, compensatory refrigeration may be performed by using the mixed coolant (for example, compensatory refrigeration by using mixed water), and the circulating pump can be reused (for example, the primary circulating pump and the secondary circulating pump are reused), thereby further simplifying a system architecture and improving system energy efficiency. In addition, this technical solution further supports integration of a controller, for example, integration of an embedded programmable logic controller (Programmable logic controller, PLC), to implement linkage in the heat dissipation systems, thereby implementing on-demand cooling and fine adjustment.

With reference to the accompanying drawings, the following describes in detail the integrated cooling source apparatus in this application and an architecture of the heat dissipation system including the integrated cooling source apparatus.

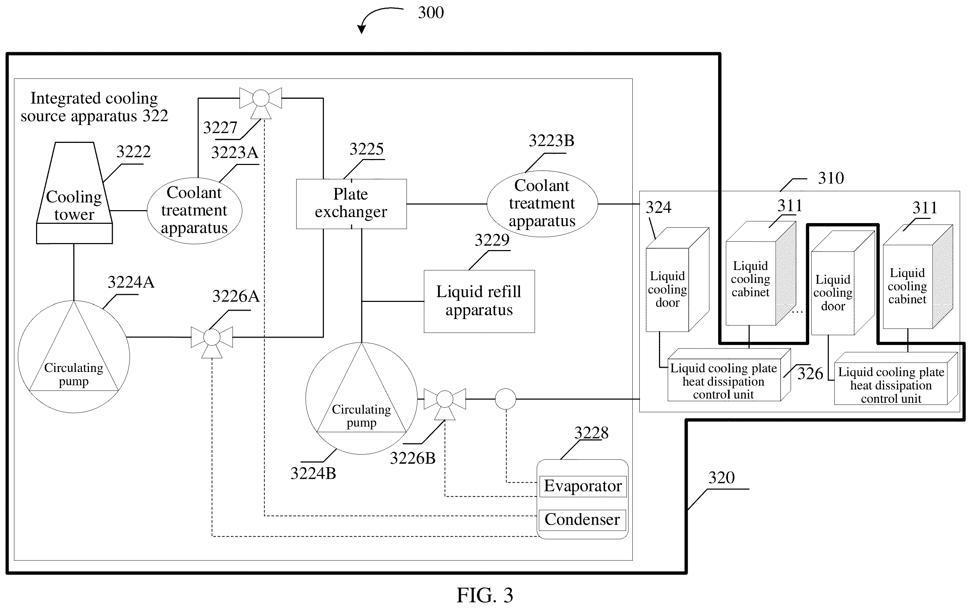

FIG. 3 is a diagram of an architecture of a data center. The data center 300 includes a liquid cooling equipment room 310 and a heat dissipation system 320. The liquid cooling equipment room 310 includes a plurality of liquid cooling cabinets 311, and the liquid cooling cabinet 311 includes one or more server nodes. The server node may be an independent physical device. The heat dissipation system 320 includes an integrated cooling source apparatus 322, a liquid cooling door 324, and a liquid cooling plate heat dissipation control unit 326. The liquid cooling plate heat dissipation control unit 326 may be an ECU or a CDU. The integrated cooling source apparatus 322 is connected to the liquid cooling door 324 through a liquid cooling pipeline and is connected to the liquid cooling plate heat dissipation control unit 326 through the liquid cooling pipeline. The liquid cooling door 324 and the liquid cooling plate heat dissipation control unit 326 are connected through the liquid cooling pipeline. The integrated cooling source apparatus 322 collaborates with the liquid cooling door 324 and the liquid cooling plate heat dissipation control unit 326 to dissipate heat for a device.

During specific implementation, the integrated cooling source apparatus 322 is configured to provide a coolant through the liquid cooling pipeline. The coolant may be a cooled liquid, for example, cold water. The coolant sequentially passes through the liquid cooling door 324 configured to dissipate heat for a first component of a device (for example, a server node) in the liquid cooling equipment room 310 and the liquid cooling plate heat dissipation control unit 326 configured to dissipate heat for a second component of the device in the liquid cooling equipment room 310. The integrated cooling source apparatus 322 is further configured to receive the coolant (for example, hot water) that is output after the liquid cooling plate heat dissipation control unit 326 dissipates heat for the second component.

In some possible implementations, the integrated cooling source apparatus 322 is specifically configured to provide a mixed coolant through the liquid cooling pipeline when a compensatory refrigeration condition is triggered, to perform compensatory refrigeration on the coolant that enters the liquid cooling door 324. A temperature of the mixed coolant meets a temperature requirement of the liquid cooling door 324. The temperature requirement of the liquid cooling door may be being less than or equal to a target temperature, and the target temperature may be 28°C or 25°C. The target temperature may vary with an application scenario. The compensatory refrigeration condition may be set based on a service requirement. For example, the compensatory refrigeration condition may be set as follows: A supply liquid temperature is greater than or equal to a preset threshold. The integrated cooling source apparatus 322 may implement compensatory refrigeration based on the mixed coolant by starting a three-way valve.

Specifically, the integrated cooling source apparatus 322 includes a cooling tower 3222, a circulating pump 3224, a three-way valve 3226, and a compensatory refrigeration chiller 3228. The three-way valve 3226 and the compensatory refrigeration chiller 3228 may be optional components. For example, in a region in which an ambient temperature is maintained at a relatively low level throughout the year, the integrated cooling source apparatus 322 does not need a compensatory refrigeration design, and therefore may not include the three-way valve 3226 or the compensatory refrigeration chiller 3228. A region in which an ambient temperature significantly changes with seasons is used as an example for description in this embodiment. Because summer is hot and an ambient temperature is relatively high, to implement compensatory refrigeration, the integrated cooling source apparatus 322 is configured with the three-way valve 3226 and the compensatory refrigeration chiller 3228 for compensatory refrigeration. The cooling tower 3222 is connected to the circulating pump 3224 through a liquid cooling pipeline, the circulating pump 3224 is connected to the compensatory refrigeration chiller 3228 through a liquid cooling pipeline, and the three-way valve 3226 is deployed on the liquid cooling pipeline connecting the circulating pump 3224 and the compensatory refrigeration chiller 3228.

The integrated cooling source apparatus 322 is specifically configured to adjust a status of the three-way valve 3226 to a three-way state when the compensatory refrigeration condition is triggered, so that a coolant from the cooling tower 3222 is divided into two paths after passing through the circulating pump 3224, and a coolant on one of the two paths is mixed with a coolant on the other path after passing through the compensatory refrigeration chiller 3228, to obtain the mixed coolant. The mixed coolant can meet the temperature requirement of the liquid cooling door 324.

The circulating pump 3224 may include a primary circulating pump 3224A and a secondary circulating pump 3224B. Correspondingly, the three-way valve 3226 includes a first three-way valve 3226A and a second three-way valve 3226B. The primary circulating pump 3224A is connected to the first three-way valve 3226A, and the secondary circulating pump is connected to the second three-way valve 3226B. The integrated cooling source apparatus 322 is specifically configured to: when the compensatory refrigeration condition is triggered, adjust a status of the first three-way valve 3226A to a three-way state, so that the coolant from the cooling tower 3222 is divided into two paths after passing through the primary circulating pump 3224A, and a coolant on one of the two paths that passes through a condenser of the compensatory refrigeration chiller 3228 and a coolant on the other path that passes through a plate heat exchanger 3225 converge before the cooling tower 3222; and adjust a status of the second three-way valve 3226B to a three-way state, so that the coolant passing through the plate heat exchanger 3225 is divided into two paths after passing through the secondary circulating pump 3224B, and a coolant on one of the two paths is mixed with a coolant on the other path after passing through an evaporator of the compensatory refrigeration chiller 3228, to obtain the mixed coolant. The mixed coolant can implement compensatory refrigeration, and can meet the temperature requirement of the liquid cooling door 324.

Considering that the cooling pump 3222 and the plate heat exchanger 3225 may output coolants to supply the coolants to downstream devices, the integrated cooling source apparatus 322 may determine, based on supply liquid temperatures of the cooling pump 3222 and the plate heat exchanger 3225 or a final supply liquid temperature of the entire integrated cooling source apparatus 322, whether to start the three-way valve 3224 to mix the coolants to perform compensatory refrigeration for the coolant that enters the liquid cooling door 324. In other words, the supply liquid temperature in the compensatory refrigeration condition may be the supply liquid temperature of the cooling tower 3222, the supply liquid temperature of the plate heat exchanger 3225 (for example, a secondary-side liquid outlet temperature), or the final supply liquid temperature of the entire integrated cooling source apparatus 322. Correspondingly, preset thresholds corresponding to supply temperatures at different points may be different. For example, a preset threshold corresponding to the supply liquid temperature of the cooling tower 3222 may be set to 32°C, and a preset threshold corresponding to the final supply liquid temperature of the entire integrated cooling source apparatus 322 may be set to 28°C.

It should be noted that the cooling tower 322 in the integrated cooling source apparatus 322 in this application may be an open cooling tower or a closed cooling tower. A coolant of the closed cooling tower flows in a closed pipe and is not in contact with external air. Heat is exchanged with the external air, sprayed water, or the like through a pipe wall of a heat exchanger. The coolant is not polluted, evaporated, or concentrated, and does not need water supplement or dosing. Therefore, performance and a service life of an associated device are ensured. A coolant of the open cooling tower circulates in an open system. The coolant is concentrated due to evaporation and needs to be supplemented. In addition, the coolant is directly in contact with air and exposed to sunlight, and is prone to pollution, for example, producing algae and salt crystallization. Therefore, the coolant usually needs to be treated, for example, dosed, to prevent the algae and salt crystallization. FIG. 3 is described by using an example in which the cooling tower 322 is an open cooling tower. Correspondingly, the integrated cooling source apparatus 322 further includes a coolant treatment apparatus 3223A, and the coolant treatment apparatus 3223A is configured to perform descaling, filtering, softening, or sterilization on the coolant. A three-way valve 3227 may be further connected between the coolant treatment apparatus 3223A and the plate heat exchanger 3225. Similarly, a coolant treatment apparatus 3223B may also be included between a liquid outlet of the liquid cooling cabinet 311 and the plate heat exchanger 3225, and is configured to perform descaling, filtering, softening, or sterilization on the coolant that is output after heat dissipation of the liquid cooling cabinet 311. The coolant treatment apparatus 3223A or the coolant treatment apparatus 3223B may be an optional component. For example, when the integrated cooling source apparatus 322 uses a closed cooling tower, the coolant treatment apparatus 3223A or the coolant treatment apparatus 3223B may not be included.

In some possible implementations, the integrated cooling source apparatus 322 may further integrate a liquid refill apparatus 3229. For example, the liquid refill apparatus 3229 may be a constant-pressure water refill apparatus. The constant-pressure water refill apparatus is a type of stabilized-pressure water refill apparatus. The stabilized-pressure water refill apparatus includes a stabilized-pressure tank, a water pump, a pressure switch, an intelligent control box, a safety valve, a base, and a pipeline, is configured to reduce a quantity of startup times of the circulating pump 3224, and may adjust a water pressure and a water volume of a system, to facilitate automatic water refill. Similarly, the liquid refill apparatus 3229 may be an optional component. When the integrated cooling source apparatus 322 does not include the liquid refill apparatus 3229, a pressure and a flow may be manually adjusted.

The integrated cooling source apparatus 322 or the heat dissipation system 320 including the integrated cooling source apparatus 322 shown in FIG. 3 has a plurality of operating states. For example, the operating states of the integrated cooling source apparatus 322 or the heat dissipation system 320 may be classified into an operating state without compensatory refrigeration and an operating state with compensatory refrigeration based on whether the compensatory refrigeration condition is triggered. The following separately describes coolant circulation paths (such as water circulation paths) in different operating states of the integrated cooling source apparatus 322 or the heat dissipation system 320.

When the integrated cooling source apparatus 322 or the heat dissipation system 320 is in the operating state without compensatory refrigeration, the coolant does not need compensatory refrigeration, and therefore does not pass through the compensatory refrigeration chiller, but circulates on a primary side and a secondary side of the plate heat exchanger 3225. The coolant provided by the cooling tower 3222 is transported to the plate heat exchanger 3225 through the primary circulating pump 3224A for heat exchange. The primary side of the plate heat exchanger 3225 may output the coolant with an increased temperature, and the coolant is treated by the coolant treatment apparatus 3223A and then returns to the cooling tower 3222, thereby implementing primary circulation. The coolant with a reduced temperature obtained by the plate heat exchanger 3225 through heat exchange may be output from the secondary side of the plate heat exchanger 3225. The coolant that is output from a secondary-side liquid outlet of the plate heat exchanger 3225 is transported to the liquid cooling door 324 through the secondary circulating pump 3224B. The liquid cooling door 324 dissipates heat for the first component based on the coolant. Then, the coolant is output from a liquid outlet of the liquid cooling door 324 and enters the liquid cooling plate heat dissipation control unit 326. The liquid cooling plate heat dissipation control unit 326 dissipates heat for the second component. The coolant that is output from a liquid outlet of the liquid cooling plate heat dissipation control unit 326 is treated by the coolant treatment apparatus 3223B and then reaches a secondary-side liquid inlet of the plate heat exchanger 3225, thereby implementing secondary circulation.

For ease of understanding, a circulation path of the coolant is further described in this application with reference to the accompanying drawings.

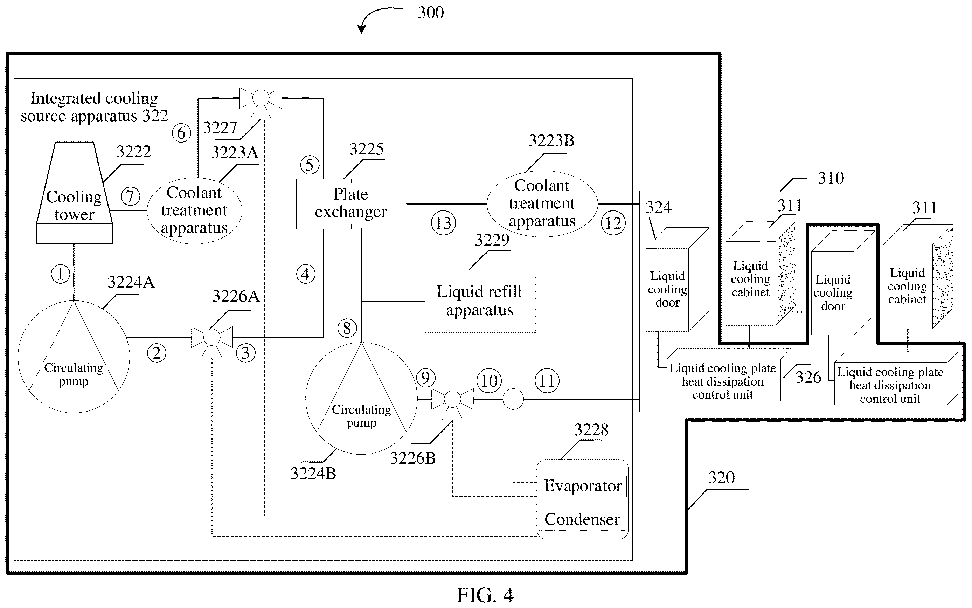

FIG. 4 is a diagram of a circulation path of a coolant in an operating state without compensatory refrigeration. The integrated cooling source apparatus 322 or the heat dissipation system 320 includes primary circulation and secondary circulation.

During primary circulation, a circulation path of the coolant is 1->2->3->4->5->6->7. In this case, three-way valves between 2->3 and 5->6 are in a two-way state. In other words, the coolant from the cooling tower 3222 passes through the primary circulating pump 3224A, reaches the first three-way valve 3224A, then is output through one path of the first three-way valve 3224A, and reaches the plate heat exchanger 3225, for example, reaches a primary-side liquid inlet of the plate heat exchanger 3225. The plate heat exchanger 322 transports the coolant to the three-way valve 3227 (for example, through a primary-side liquid outlet). The three-way valve 3227 transports the coolant to the coolant treatment apparatus 3223A for treatment, and then the coolant returns to the cooling tower 3222.

During secondary circulation, a circulation path of the coolant is 8->9->10->11->12->13. In this case, a three-way valve between 9->10 is in a two-way state. In other words, after undergoing heat exchange performed by the plate heat exchanger 3225, the coolant from the open cooling tower 3222 is transported to the secondary circulating pump 3224B through a secondary-side liquid outlet of the plate heat exchanger 3225. The secondary circulating pump 3224B transports the coolant to the second three-way valve 3224B. Because the second three-way valve 3224B is in a two-way state, the coolant is output from one path (normally closed path) of the second three-way valve 3224B, and reaches the liquid cooling equipment room 310. The coolant first enters the liquid cooling door 324 to dissipate heat for a low-heat generation component such as a memory or a hard disk in the server node of the liquid cooling cabinet 311. The coolant takes away the heat of the memory or the hard disk, so that a temperature of the coolant may increase. Then, the heated coolant may enter the liquid cooling plate heat dissipation control unit 326 (for example, an ECU). The ECU may control a flow rate of the coolant and the like to dissipate heat for a high-heat generation component such as a CPU in the server node of the liquid cooling cabinet 311. The coolant takes away the heat of the CPU, so that the temperature of the coolant may further increase. After being treated by the coolant treatment apparatus 3223B, the heated coolant may reach the plate heat exchanger 3225 (for example, the secondary-side liquid inlet of the plate heat exchanger 3225). The plate heat exchanger 3225 may exchange heat for the heated coolant for cycle use.

When the integrated cooling source apparatus 322 or the heat dissipation system 320 is in the operating state with compensatory refrigeration, the coolant needs compensatory refrigeration, to meet a temperature requirement of the liquid cooling door 324. In other words, in the operating state with compensatory refrigeration, the coolant further needs to enter the compensatory refrigeration chiller 3228. Specifically, when circulating on the primary side and the secondary side of the plate heat exchanger 3225, the coolant is further shunted into the compensatory refrigeration chiller 3228. The coolant provided by the cooling tower 3222 is transported to the first three-way valve 3226A through the primary circulating pump 3224A, and is divided into two paths by the first three-way valve 3226A for separate transportation to the plate heat exchanger 3225 and the compensatory refrigeration chiller 3228 for heat exchange. A coolant that is output from the primary-side liquid outlet of the plate heat exchanger 3225 and a coolant that is output from a condenser of the compensatory refrigeration chiller 3228 converge before the cooling tower 3222 after being treated by the coolant treatment apparatus 3223A, thereby implementing primary circulation. The coolant with a reduced temperature obtained by the plate heat exchanger 3225 through heat exchange may be output from the secondary side of the plate heat exchanger 3225. The coolant that is output from the secondary-side liquid outlet of the plate heat exchanger 3225 is transported to the second three-way valve 3226B through the secondary circulating pump 3224B, and is divided into two paths by the second three-way valve 3226B. A coolant on one path enters an evaporator of the compensatory refrigeration chiller 3228 for heat exchange, and the coolant that is output by the evaporator is mixed with a coolant on the other path, to form a mixed coolant. The mixed coolant first enters the liquid cooling door 324, and then enters the liquid cooling plate heat dissipation control unit 326. The coolant that is output from a liquid outlet of the liquid cooling plate heat dissipation control unit 326 is treated by the coolant treatment apparatus 3223B and then reaches the secondary-side liquid inlet of the plate heat exchanger 3225, thereby implementing secondary circulation.

For ease of understanding, a circulation path of the coolant is further described in this application with reference to the accompanying drawings.

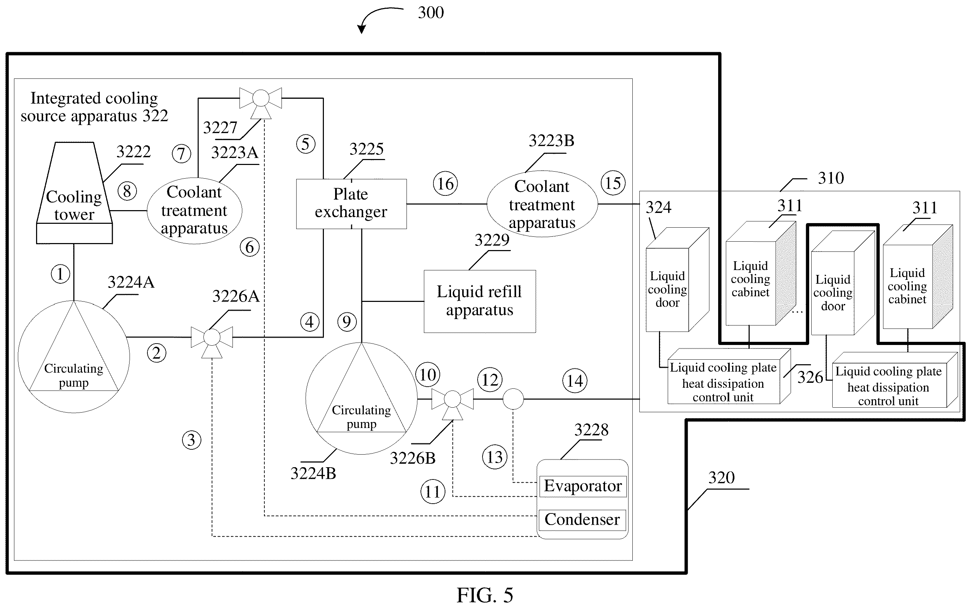

FIG. 5 is a diagram of a circulation path of a coolant in an operating state with compensatory refrigeration. The integrated cooling source apparatus 322 or the heat dissipation system 320 includes primary circulation and secondary circulation.

During primary circulation, circulation paths of the coolant may be 1->2->4->5->7->8 and 1->2->3->6->7->8. Three-way valves between 2->3 and 5->7 are in a three-way state. A part of a coolant that is output from a point 2 is shunted into a condenser of the compensatory refrigeration chiller 3228 through a three-way valve, then passes through a point 6, and converges at a three-way valve before the cooling tower 3222. In other words, the coolant from the cooling tower 3222 passes through the primary circulating pump 3224A, and reaches the first three-way valve 3224A. Because the first three-way valve 3224A is in a three-way state, the coolant is divided into two paths. A coolant on one path passes through the plate heat exchanger 3225, and reaches the coolant treatment apparatus 3223A through one path of the three-way valve 3227. After being condensed by the condenser of the compensatory refrigeration chiller 3228, a coolant on the other path reaches the coolant treatment apparatus 3223A through another path of the three-way valve 3227. The coolant treatment apparatus 3223A performs descaling, filtering, softening, or sterilization for the coolants on the two paths, and then the coolants converge before the cooling tower.

During secondary circulation, circulation paths of the coolant may be 9->10->12->14->15->16 and 9->10->11->13->14->15->16. A three-way valve between 10->12 is in a three-way state. A part of a coolant that is output from a point 12 passes through a point 11, and after being cooled by the evaporator of the compensatory refrigeration chiller 3228, is mixed with the coolant at the point 12 to become a cooling source that meets a cooling temperature requirement of the server node. In other words, after heat exchange is performed on the coolant from the cooling tower 3222 by using the plate heat exchanger 3225, the coolant is transported to the secondary circulating pump 3224B. The secondary circulating pump 3224B transports the coolant to the second three-way valve 3224B. Because the second three-way valve 3224B is in a three-way state, the coolant is separately output from two paths of the second three-way valve 3224B. A coolant on one path reaches the evaporator of the compensatory refrigeration chiller 3228 for evaporation and cooling, and then is mixed with a coolant on the other path. A temperature of the mixed coolant can meet a temperature requirement of the liquid cooling door 324, and the mixed coolant may be input to the liquid cooling door 324. The liquid cooling door 324 dissipates heat for a low-heat generation component in the device based on the mixed coolant. The coolant takes away the heat of the low-heat generation component, so that a temperature of the coolant may increase. Then, the heated coolant may enter the liquid cooling plate heat dissipation control unit 326 (for example, an ECU). The ECU may control a flow rate of the coolant and the like to dissipate heat for a high-heat generation component in the server node of the liquid cooling cabinet 311. After being treated by the coolant treatment apparatus 3223B, the heated coolant may reach the plate heat exchanger 3225. The plate heat exchanger 3225 may exchange heat for the heated coolant for cycle use.

It should be noted that a same point number in FIG. 4 and FIG. 5 may indicate different points. For example, a point number 3 in FIG. 4 and a point number 3 in FIG. 5 respectively indicate different paths of a three-way valve.

In the foregoing solution, a cooling source end may be integrally integrated. For example, the circulating pump 3224 (for example, the primary circulating pump 3224A and the secondary circulating pump 3224B), the plate heat exchanger 3225, the three-way valve 3226 (the first three-way valve 3226A and the second three-way valve 3226B), and the compensatory refrigeration chiller 3228 may be integrated in a container, and then the container is integrated with the cooling tower 3222, to form the integrated cooling source apparatus 322. In the apparatus, a compensatory refrigeration design is based on a mixed coolant solution in which the primary circulating pump and the secondary circulating pump are reused. This greatly simplifies a system architecture and improves system energy efficiency.

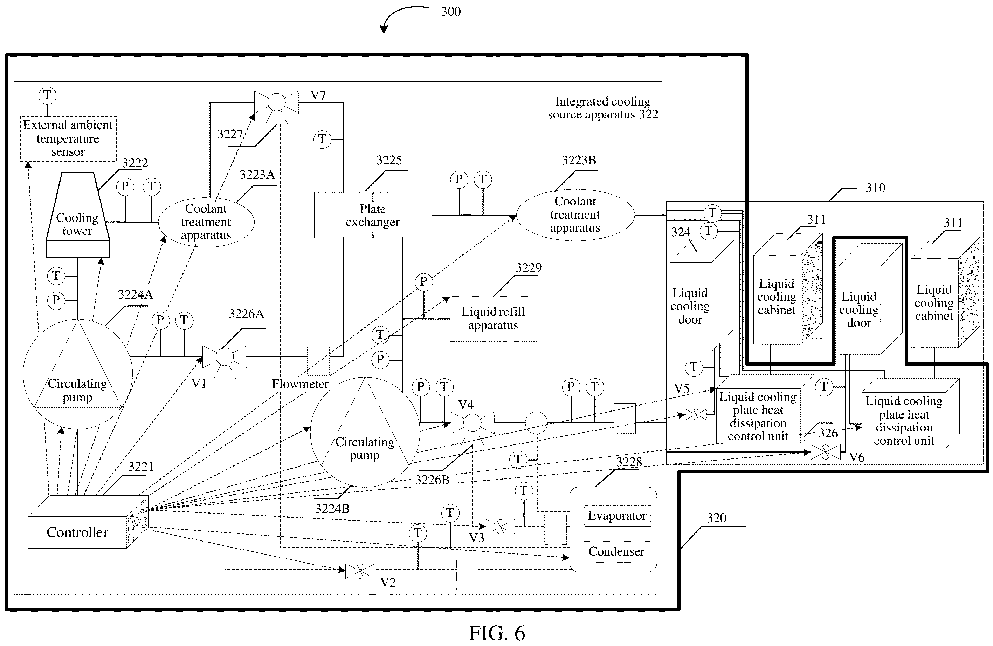

Further, refer to FIG. 6. The integrated cooling source apparatus 322 may further integrate a controller 3221. The controller 3221 is configured to implement linkage control based on a liquid temperature, to implement on-demand cooling and form a normal-temperature equipment room. The controller 3221 may be implemented by using a PLC control board. Specifically, the controller 3221 may detect whether the compensatory refrigeration condition is triggered. For example, the controller 3221 may detect whether the supply liquid temperature (which is also referred to as a supply water temperature when the coolant is cold water) is greater than or equal to the preset threshold. Specifically, the integrated cooling source apparatus 322 may be deployed with a temperature sensor at a specified point, and the temperature sensor may detect a temperature of a coolant at the specified point. A communication connection is established between the temperature sensor and the controller 3221, and the temperature sensor may report a detection result to the controller 3221. In this way, the controller 3221 may obtain the supply liquid temperature.

When the supply liquid temperature is greater than or equal to the preset threshold, it indicates that the compensatory refrigeration condition is triggered, and the controller may control a status of the three-way valve 3224 to be a three-way state, and start the compensatory refrigeration chiller 3228, to implement compensatory refrigeration control.

When the compensatory refrigeration condition is triggered, the controller 3221 may adjust a status of the first three-way valve 3224A to a three-way state, so that the coolant from the cooling tower 3222 is divided into two paths after passing through the primary circulating pump 3224A, and a coolant on one of the two paths that passes through a condenser of the compensatory refrigeration chiller 3228 and a coolant on the other path that passes through a plate heat exchanger 3225 converge before the cooling tower; and adjust a status of the second three-way valve 3224B to a three-way state, so that the coolant passing through the plate heat exchanger 3225 is divided into two paths after passing through the secondary circulating pump 3224B, and a coolant on one of the two paths is mixed with a coolant on the other path after passing through an evaporator of the compensatory refrigeration chiller 3228, to obtain the mixed coolant. The mixed coolant meets the temperature requirement of the liquid cooling door 324.

When performing compensatory refrigeration control, the controller 3221 may determine a bypass flow of the three-way valve 3224 based on the supply liquid temperature, a cooling temperature of the compensatory refrigeration chiller 3228, a required temperature of the liquid cooling door, and a flow required for heat dissipation, determine a valve opening proportion of the three-way valve 3224 based on the bypass flow, and adjust the status of the three-way valve 3224 to the three-way state based on the valve opening proportion.

Further, the controller 3221 may control the supply liquid temperature to vary with an ambient temperature, to reduce overall power consumption and implement energy saving control. Similarly, the controller 3221 may further perform energy saving control on the primary circulating pump 3224A and the secondary circulating pump 3224B, to improve system energy efficiency.

FIG. 6 is still used as an example to describe in detail linkage control on the controller 3221.

A control point of the controller 3221 includes but is not limited to a fan frequency of the cooling tower 3222, a frequency of the primary circulating pump 3224A, an opening of an electric valve (including a three-way valve or a two-way valve), an operating parameter of the compensatory refrigeration chiller 3228, an operating parameter of the liquid refill apparatus 3229, an operating parameter of the coolant treatment apparatus 3223, or an operating parameter of the liquid cooling plate heat dissipation control unit 326 (such as an ECU). The operating parameter of the compensatory refrigeration chiller 3228 includes an input frequency and a liquid outlet temperature of an inverter compressor. The operating parameter of the liquid refill apparatus 3229 may include a start/stop status of a liquid pump (for example, a water pump). The operating parameter of the coolant treatment apparatus 3223 includes a start/stop status of the coolant treatment apparatus 3223. The operating parameter of the liquid cooling plate heat dissipation control unit 326 includes an opening of a primary-side proportional valve (for example, reused V5 or V6 or a separate proportional valve), a secondary-side supply liquid temperature, and a frequency of a liquid pump.

The controller 3221 may collect data, perform analysis based on the collected data, and control the foregoing control point by using an analysis result. The data collected by the controller 3221 may include one or more of an operating parameter of the cooling tower 3222, an external ambient temperature, an operating parameter of the primary circulating pump 3224A, an opening of an electric valve (including a three-way valve or a two-way valve, for example, V1 to V7 in the figure), a temperature collected by the temperature sensor, a pressure collected by a pressure sensor, the operating parameter of the liquid refill apparatus 3229, the operating parameter of the coolant treatment apparatus 3223, the operating parameter of the compensatory refrigeration chiller 3228, a parameter of a flowmeter, and the operating parameter of the liquid cooling plate heat dissipation control unit 326.

The operating parameter of the cooling tower 3222 collected by the controller 3221 includes one or more of a fan frequency, power consumption, a liquid outlet temperature, and a liquid inlet temperature. The ambient temperature collected by the controller 3221 includes a dry bulb temperature and a wet bulb temperature. The dry bulb temperature is an actual temperature of air in contact with a surface of a bulb. The wet bulb temperature is a temperature of the bulb obtained after water evaporation takes away heat when water is attached to the surface of the bulb. An evaporation capacity of the water is related to air humidity. Higher air humidity indicates a smaller evaporation capacity, less heat taken away by evaporation, and a smaller difference between the dry bulb temperature and the wet bulb temperature. Lower air humidity indicates a larger evaporation capacity of the water, more heat taken away by evaporation, and a larger difference between the dry bulb temperature and the wet bulb temperature. Therefore, a change rule of the difference between the dry bulb temperature and the wet bulb temperature may be used to reflect current air humidity. Based on this, the wet bulb temperature may also be determined by using the dry bulb temperature and relative humidity. The operating parameter of the primary circulating pump 3224A collected by the controller 3221 includes one or more of an operating frequency, power consumption, an inlet pressure, and an outlet pressure. The operating parameter of the liquid refill apparatus 3229 collected by the controller 3221 may include a start/stop status of the liquid refill apparatus 3229. The operating parameter of the coolant treatment apparatus 3223 collected by the controller 3221 may include a start/stop status of the coolant treatment apparatus 3223. The operating parameter of the compensatory refrigeration chiller 3228 collected by the controller 3221 includes an input frequency and a liquid outlet temperature of an inverter compressor. The operating parameter of the liquid cooling plate heat dissipation control unit 326 collected by the controller 3221 may include an opening of a primary-side proportional valve, a secondary-side supply liquid temperature, and a frequency of a liquid pump.

When the controller 3221 detects that the supply liquid temperature is greater than or equal to the preset threshold, for example, detects for three consecutive times that the supply liquid temperature of the integrated cooling source apparatus 322 is greater than 32 degrees Celsius, the controller 3221 may control statuses of the first three-way valve 3224A and the second three-way valve 3224B (for example, V1 and V4 in FIG. 6) to be a three-way state, and start the compensatory refrigeration chiller 3228. The three-way valve usually includes a normally open path and a normally closed path. In the example in FIG. 6, an electric valve (for example, the two-way valves V2 and V3 in FIG. 6) is further deployed on the normally open path. Therefore, the controller 3221 may further control statuses of V2 and V3 to be a valve open state, so that the normally open path is closed.

The controller 3221 is configured to: determine a bypass flow of the three-way valve based on the supply liquid temperature, a cooling temperature of the compensatory refrigeration chiller 3228, a required temperature of the liquid cooling door 324, and a flow required for heat dissipation, then determine a valve opening proportion of the three-way valve (for example, V1 or V4) based on the bypass flow, and adjust the status of the three-way valve to the three-way state based on the valve opening proportion.

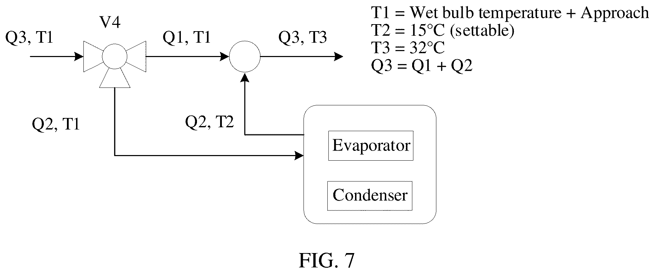

The following uses V4 as an example to describe a process of determining the valve opening proportion. Specifically, a valve opening proportion (an opening) of the valve V4 is in one-to-one correspondence with a flow, and the valve opening proportion (also referred to as a bypass opening) of V4 may be determined by calculating a required bypass flow. The bypass flow can be calculated according to conservation of energy. As shown in FIG. 7, a temperature of a coolant flowing into V4 is denoted as T1, and a flow of the coolant flowing into V4 is a flow required for heat dissipation (for example, a flow required for heat dissipation of the server in the liquid cooling cabinet 311), and is denoted as Q3. When passing through V4, the coolant is divided into two paths, temperatures of coolants on the two paths remain unchanged and are still T1, and flows of the coolants on the two paths are respectively Q1 and Q2. After the coolant whose flow is Q2 passes through the compensatory refrigeration chiller 3228, a temperature decreases to T2, and then the coolant converges with the coolant whose flow is Q1.

Based on the law of conservation of energy, the following model can be established:

$$Q1 * T1 + Q2 * T2 = Q3 * T3 \qquad\qquad (1)$$

$$Q3 = Q1 + Q2 \qquad\qquad (2)$$

Q3 is the flow required for heat dissipation of the server, Q3 may be usually obtained through measurement by using a sensor, and T1 may be obtained based on a wet bulb temperature and an approach (approach) of the cooling tower 3222. The approach of the cooling tower 3221 may be a difference between a temperature (for example, a water temperature) of a coolant cooled by the cooling tower 3221 and the wet bulb temperature, and indicates a degree to which the temperature of the coolant cooled by the cooling tower 3221 approaches the wet bulb temperature. Generally, the approach of the cooling tower 3221 may be 3°C to 4°C. T2 may be set. For example, T2 may be set to 15°C. Similarly, T3 may be set to 32°C. Based on the formula in the foregoing model, Q1 and Q2 (bypass flow) may be solved.

After determining the valve opening proportion based on the bypass flow, the controller 3221 may deliver the valve opening proportion to the corresponding three-way valve, to control the status of the three-way valve to be the three-way state based on the valve opening proportion.

Similarly, when starting the compensatory refrigeration chiller 3228, the controller 3221 may deliver a start instruction to the compensatory refrigeration chiller. After receiving the start instruction, the compensatory refrigeration chiller 3228 may start compensatory refrigeration.

Further, to avoid disadvantages of a high-temperature equipment room, improve reliability of an information technology (information technology, IT) device, reduce IT power consumption, and implement global optimization, the integrated cooling source apparatus 322 may further perform global linkage control based on a coolant temperature.

In a control manner, the controller 3221 may control a supply liquid temperature of the cooling tower based on the wet bulb temperature and an approach of the cooling tower, and then control a secondary-side temperature of the plate heat exchanger 3225 based on the supply liquid temperature and an approach of the plate heat exchanger.

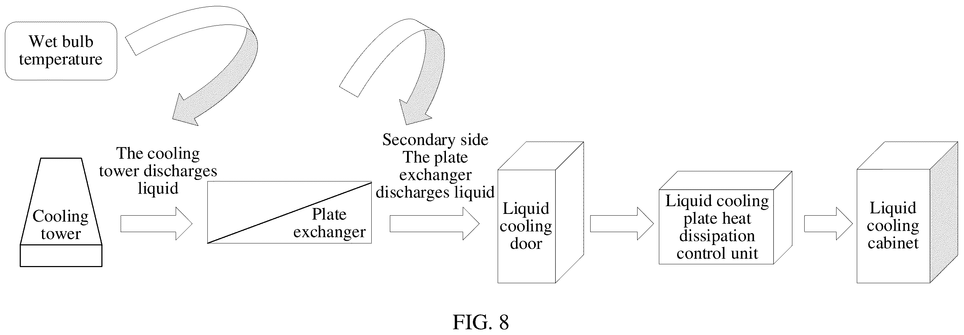

Specifically, refer to a diagram of temperature control shown in FIG. 8. The cooling tower 3222 controls the supply liquid temperature (which is specifically a water outlet temperature when the coolant is water) of the cooling tower 3222 by using the wet bulb temperature and the approach of the cooling tower 3222, and then the secondary-side temperature of the plate heat exchanger 3225 is controlled by using the supply liquid temperature of the cooling tower 3222 and the approach of the plate heat exchanger 3225. In other words, when the secondary-side temperature of the plate heat exchanger 3225 is controlled, two anchors may be used for control. In this way, the supply liquid temperature of the integrated cooling source apparatus 322 varies with the wet bulb temperature. When the wet bulb temperature of an external environment decreases, the supply liquid temperature of the integrated cooling source apparatus 322 also decreases accordingly. On a side of the liquid cooling equipment room 310, an air exhaust temperature of the liquid cooling door decreases, and the temperature of the liquid cooling equipment room 310 decreases.

The controller 3221 may further manage the liquid cooling plate heat dissipation control unit 326 such as an ECU. A secondary-side temperature may be set to a primary-side temperature plus an approach. In this case, a supply liquid temperature of the liquid cooling plate heat dissipation control unit 326 varies with the wet bulb temperature of the external environment. When the temperature of the external environment is relatively low, in a same service model, a temperature of the server node in the liquid cooling cabinet 311 decreases, and IT power consumption decreases.

In another control manner, the controller 3221 may control a secondary-side temperature of the plate heat exchanger 3225 based on the wet bulb temperature, an approach of the cooling tower 3222, and an approach of the plate heat exchanger 3225. In other words, the controller 3221 directly performs temperature control by using the secondary-side temperature of the plate heat exchanger 3225 as an anchor.

In some possible implementations, the controller 3221 may further perform energy saving control on the circulating pump 3224, for example, the primary circulating pump 3224A and the secondary circulating pump 3224B. The plate heat exchanger 3225 is disposed between the primary circulating pump 3224A and the secondary circulating pump 3224B. The controller 3221 may perform energy saving control on the circulating pump 3224 based on a liquid outlet temperature or a liquid inlet temperature of the plate heat exchanger 3225.

For the primary circulating pump 3224A, the controller 3221 may separately deploy temperature sensors at a primary-side liquid inlet and a primary-side liquid outlet of the plate heat exchanger 3225 after the primary circulating pump 3224A. The controller 3221 is configured to detect temperatures at the primary-side liquid outlet and the primary-side liquid inlet of the plate heat exchanger 3225 after the primary circulating pump 3224A, for example, receive the temperatures at the primary-side liquid outlet and the primary-side liquid inlet that are reported by the temperature sensors. When a temperature difference between the primary-side liquid outlet and the primary-side liquid inlet of the plate heat exchanger 3225 is less than a specified value (for example, 9°C), the controller 3221 is configured to control the primary circulating pump 3224A to operate at a variable frequency, to reduce power consumption. Similarly, the controller 3221 may control the primary circulating pump 3224A based on the approach of the plate heat exchanger 3225, to reduce power consumption. During specific implementation, the controller 3221 may separately deploy temperature sensors at a primary-side liquid outlet and a secondary-side liquid inlet of the plate heat exchanger 3225. When it is detected that a temperature difference between the primary-side liquid outlet and the secondary-side liquid inlet of the plate heat exchanger 3225 is less than the approach (for example, 1°C to 1.5°C) of the plate heat exchanger 3225, the primary circulating pump 3224A is controlled to operate at a variable frequency.

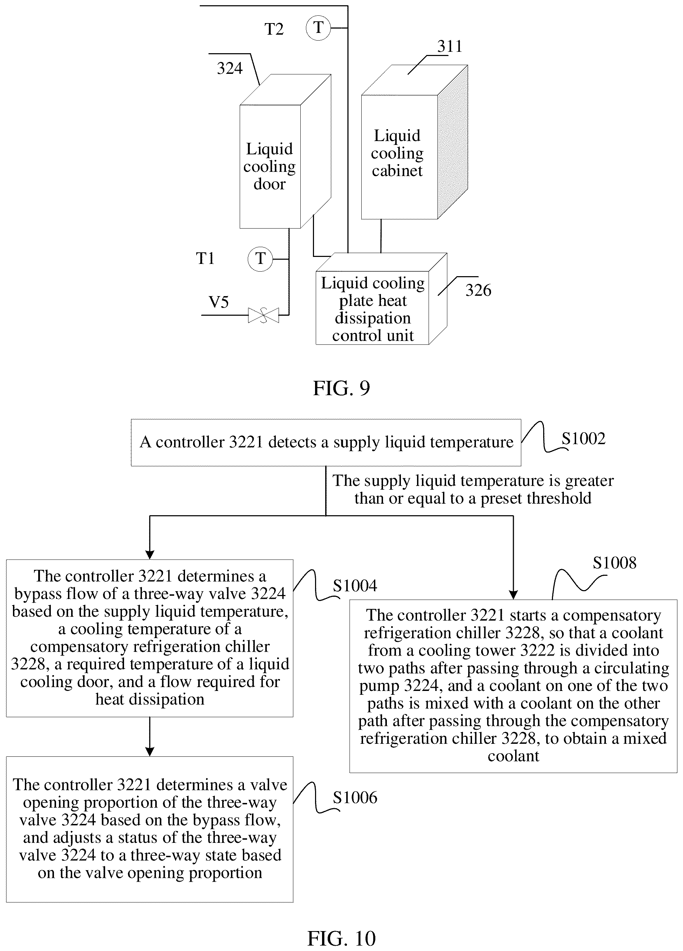

For the secondary circulating pump 3224B, refer to FIG. 9. The controller 3221 may deploy temperature sensors at a liquid outlet of the liquid cooling plate heat dissipation control unit 326 and a liquid inlet of the liquid cooling door 324. In addition, the controller 3221 may further deploy an electric valve at the liquid inlet of the liquid cooling door 324, and the controller 3221 is configured to detect a temperature T1 at the liquid inlet of the liquid cooling door 324 and a temperature T2 at the liquid outlet of the liquid cooling plate heat dissipation control unit 326. When a temperature difference (T2-T1) between the liquid outlet of the liquid cooling plate heat dissipation control unit 326 and the liquid inlet of the liquid cooling door 324 is less than a specified value (for example, 9°C), the controller 3221 is further configured to reduce an opening of the electric valve deployed at the liquid inlet of the liquid cooling door 324. In this way, a flow can be reduced, and power consumption of the secondary circulating pump 3224B can be reduced.

Based on the integrated cooling source apparatus 322 and the heat dissipation system 320 in the foregoing embodiments, this application further provides a heat dissipation control method.

With reference to the accompanying drawings, the following describes in detail the heat dissipation control method disclosed in this application.

FIG. 10 is a flowchart of a heat dissipation control method. The method is applied to an integrated cooling source apparatus 322, and the integrated cooling source apparatus 322 includes a controller 3221, a cooling tower 3222, a circulating pump 3224, a three-way valve 3226, and a compensatory refrigeration chiller 3228. The cooling tower 3222 is connected to the circulating pump 3224 through a liquid cooling pipeline, and the circulating pump 3224 is connected to the compensatory refrigeration chiller 3228 through a liquid cooling pipeline. The three-way valve 3224 is deployed on the liquid cooling pipeline connecting the circulating pump 3224 and the compensatory refrigeration chiller 3228. The method includes the following steps.

S1002: The controller 3221 detects a supply liquid temperature. When the supply liquid temperature is greater than or equal to a preset threshold, S 1004 is performed.

Specifically, the controller 3221 may deploy a temperature sensor at a liquid outlet of the cooling tower 3222, and may detect a supply liquid temperature (for example, a water outlet temperature) of the cooling tower 3222 by using the temperature sensor. In some examples, the controller 3221 may alternatively deploy a temperature sensor at a liquid outlet (for example, a secondary-side liquid outlet) of the plate heat exchanger 3225, or deploy a temperature sensor at a tail end (an output end) of the entire integrated cooling source apparatus 322, and detect a supply liquid temperature of the plate heat exchanger 3225 or a final supply liquid temperature of the entire integrated cooling source apparatus 322 by using the temperature sensor.

When the supply liquid temperature is greater than or equal to the preset threshold, it indicates that a compensatory refrigeration condition is triggered, and the controller 3221 may perform compensatory refrigeration control. The controller 3221 may control the three-way valve 3224 to be in a three-way state, to mix coolants on different paths for compensatory refrigeration.

S1004: The controller 3221 determines a bypass flow of the three-way valve 3224 based on the supply liquid temperature, a cooling temperature of the compensatory refrigeration chiller 3228, a required temperature of a liquid cooling door, and a flow required for heat dissipation.

A flow of a coolant entering the three-way valve 3224 is equal to a sum of flows of different output paths of the three-way valve. A sum of energy of coolants on different paths is equal to energy of a mixed coolant. Based on this, the controller 3221 may perform modeling by using the law of conservation of energy based on the supply liquid temperature, the cooling temperature of the compensatory refrigeration chiller 3228, the required temperature of the liquid cooling door, and the flow required for heat dissipation, to establish the model shown in FIG. 7. The controller 3221 determines the bypass flow of the three-way valve 3224 by solving the model.

In some possible implementations, the circulating pump 3224 includes a primary circulating pump 3224A and a secondary circulating pump 3224B, and the three-way valve 3226 includes a first three-way valve 3226A and a second three-way valve 3226B. Correspondingly, the controller 3221 determines a bypass flow of the second three-way valve 3224B based on the supply liquid temperature, the cooling temperature of the compensatory refrigeration chiller 3228, the required temperature of the liquid cooling door 324, and the flow required for heat dissipation, and the controller 3221 may further determine a bypass flow of the first three-way valve 3224A in a similar manner.

S1006: The controller 3221 determines a valve opening proportion of the three-way valve 3224 based on the bypass flow, and adjusts a status of the three-way valve 3224 to a three-way state based on the valve opening proportion.

There is a correspondence between the bypass flow of the three-way valve 3224 and the valve opening proportion of the three-way valve 3224. The controller 3221 may determine the valve opening proportion of the three-way valve 3224 based on the bypass flow. Then, the controller 3221 may deliver the valve opening proportion to the three-way valve 3224, to adjust the status of the three-way valve 3224 to the three-way state based on the valve opening proportion.

When the three-way valve 3226 includes the first three-way valve 3226A and the second three-way valve 3226B, the controller 3221 may determine a valve opening proportion of the first three-way valve 3226A based on the bypass flow of the first three-way valve 3226A, and determine a valve opening proportion of the second three-way valve 3226B based on the bypass flow of the second three-way valve 3226B.

The controller 3221 may adjust a status of the first three-way valve 3226A to a three-way state based on the valve opening proportion of the first three-way valve 3226A, so that a coolant from the cooling tower 3222 is divided into two paths after passing through the primary circulating pump 3224A, and a coolant on one of the two paths that passes through a condenser of the compensatory refrigeration chiller 3228 and a coolant on the other path that passes through the plate heat exchanger 3225 converge before the cooling tower 3222.

The controller 3221 may adjust a status of the second three-way valve 3226B to a three-way state based on the valve opening proportion of the second three-way valve 3226B, so that the coolant passing through the plate heat exchanger 3225 is divided into two paths after passing through the secondary circulating pump 3224B, and a coolant on one of the two paths is mixed with a coolant on the other path after passing through an evaporator of the compensatory refrigeration chiller 3228, to obtain a mixed coolant.

It should be noted that S 1004 and S 1006 are a specific implementation in which the controller 3221 controls the status of the three-way valve 3224 to be the three-way state. In another possible implementation in this embodiment of this application, the controller 3221 may alternatively control the status of the three-way valve 3224 to be the three-way state based on a preset valve opening proportion (for example, a default valve opening proportion).

S1008: The controller 3221 starts the compensatory refrigeration chiller 3228, so that a coolant from the cooling tower 3222 is divided into two paths after passing through the circulating pump 3224, and a coolant on one of the two paths is mixed with a coolant on the other path after passing through the compensatory refrigeration chiller 3228, to obtain a mixed coolant.

Specifically, the controller 3221 may deliver a start instruction to the compensatory refrigeration chiller 3228, to start the compensatory refrigeration chiller 3228.

It should be noted that S 1004 and S 1006 may be performed in parallel or in sequence with S 1008. This is not limited in this embodiment of this application.

In some possible implementations, the controller 3221 may further perform global temperature control, or perform energy saving control on the circulating pump 3224.

When performing global temperature control, the controller 3221 may control a supply liquid temperature of the cooling tower based on a wet bulb temperature and an approach of the cooling tower, and then control a secondary-side temperature of the plate heat exchanger 3225 based on the supply liquid temperature and an approach of the plate heat exchanger, so that the supply liquid temperature of the integrated cooling source apparatus 322 varies with the wet bulb temperature. The controller 3221 may alternatively control a secondary-side temperature of the plate heat exchanger 3225 based on a wet bulb temperature, an approach of the cooling tower 3222, and an approach of the plate heat exchanger 3225, so that the supply liquid temperature of the integrated cooling source apparatus 322 varies with the wet bulb temperature.

When performing energy saving control on the circulating pump 3224, the controller 3221 may detect temperatures at a primary-side liquid outlet and a primary-side liquid inlet of the plate heat exchanger 3225 after the circulating pump (for example, the primary circulating pump 3224A), and when a temperature difference between the primary-side liquid outlet and the primary-side liquid inlet of the plate heat exchanger 3225 is less than a specified value, control the circulating pump (for example, the primary circulating pump 3224A) to operate at a variable frequency, so that power consumption of the primary circulating pump 3224A can be reduced. In some examples, the controller 3221 also supports energy saving control on the primary circulating pump 3224A based on the approach of the plate heat exchanger 3225. Specifically, the controller 3221 detects that a temperature difference between a primary-side liquid outlet and a secondary-side liquid inlet of the plate heat exchanger 3225 is less than the approach of the plate heat exchanger 3225, and controls the primary circulating pump 3224A to operate at a variable frequency, to reduce power consumption of the primary circulating pump 3224A.

The controller 3221 may alternatively detect temperatures at a liquid outlet of the liquid cooling plate heat dissipation control unit 326 (for example, an ECU) and a liquid inlet of the liquid cooling door 324, and when a temperature difference between the liquid outlet of the liquid cooling plate heat dissipation control unit 326 and the liquid inlet of the liquid cooling door 324 is less than a specified value, reduce an opening of an electric valve deployed at the liquid inlet of the liquid cooling door 324, so that power consumption of the secondary circulating pump 3224B can be reduced.

Based on the foregoing heat dissipation control method, an embodiment of this application further provides a controller 3221. The controller 3221 may be a PLC control board. The PLC control board is a digital electronic device with a microprocessor, and is a digital logic controller used for automatic control. The PLC control board may execute control instructions (computer-readable instructions), to perform the foregoing heat dissipation control method.

Specifically, the controller 3221 includes a processor and an input/output module. The processor may be a CPU or a microprocessor, and the input/output module may be a network adapter or a transceiver. The input/output module may communicate with the circulating pump 3224 and the three-way valve 3226 in the integrated cooling source apparatus 322. For example, the input/output module may receive (input) and send (output) electrical or electronic signals of various types, and use the signals to control or supervise almost all types of mechanical and electrical systems. The processor may execute computer-readable instructions, so that the controller 3221 performs the foregoing heat dissipation control method.

Further, the controller 3221 may include a memory, and the memory may store the computer-readable instructions. Correspondingly, the processor is specifically configured to load the computer-readable instructions from the memory, and execute the computer-readable instructions, to enable the controller 3221 to perform the foregoing heat dissipation control method.

It should be understood that, in this application, "at least one (item)" refers to one or more, and "a plurality of" refers to two or more. The term "and/or" describes an association relationship of associated objects, and indicates that three relationships may exist. For example, "A and/or B" may indicate the following three cases: Only A exists, only B exists, and both A and B exist. A and B may be singular or plural. The character "/" generally indicates an "or" relationship between associated objects. "At least one of the following items (pieces)" or a similar expression thereof refers to any combination of these items, including a single item (piece) or any combination of a plurality of items (pieces). For example, at least one of a, b, or c may represent a, b, c, "a and b", "a and c", "b and c", or "a, b, and c", where a, b, and c may be singular or plural.

Finally, it should be noted that the foregoing embodiments are merely used to describe the technical solutions of the present invention, but not limit the technical solutions of the present invention. Although the present invention is described in detail with reference to the foregoing embodiments, persons of ordinary skill in the art should understand that they may still modify the technical solutions described in the foregoing embodiments, or perform equivalent replacement on some technical features thereof. However, these modifications or replacements do not make the essence of the corresponding technical solutions depart from the protection scope of the technical solutions in embodiments of the present invention.

## Claims

1. An integrated cooling source apparatus, wherein the integrated cooling source apparatus is connected to an air-to-liquid heat exchange mode component through a liquid cooling pipeline and is connected to a liquid-to-liquid heat exchange mode component through the liquid cooling pipeline, and the air-to-liquid heat exchange mode component and the liquid-to-liquid heat exchange mode component are connected through the liquid cooling pipeline;

   the integrated cooling source apparatus is configured to provide a coolant through the liquid cooling pipeline, wherein the coolant flows through the air-to-liquid heat exchange mode component configured to dissipate heat for a first component of a device and the liquid-to-liquid heat exchange mode component configured to dissipate heat for a second component of the device; and
   the integrated cooling source apparatus is further configured to receive the coolant that is output after heat is dissipated for the second component.

2. The apparatus according to claim 1, wherein the coolant sequentially flows through the air-to-liquid heat exchange mode component configured to dissipate heat for the first component of the device and the liquid-to-liquid heat exchange mode component configured to dissipate heat for the second component of the device.

3. The apparatus according to claim 2, wherein the integrated cooling source apparatus is specifically configured to: provide a mixed coolant through the liquid cooling pipeline when a compensatory refrigeration condition is triggered, wherein a temperature of the mixed coolant meets a temperature requirement of the air-to-liquid heat exchange mode component.

4. The apparatus according to claim 3, wherein the integrated cooling source apparatus comprises a cooling tower, a circulating pump, a three-way valve, and a compensatory refrigeration chiller, the cooling tower is connected to the circulating pump through a liquid cooling pipeline, the circulating pump is connected to the compensatory refrigeration chiller through a liquid cooling pipeline, and the three-way valve is deployed on the liquid cooling pipeline connecting the circulating pump and the compensatory refrigeration chiller; and
the integrated cooling source apparatus is specifically configured to:
adjust a status of the three-way valve to a three-way state when the compensatory refrigeration condition is triggered, so that a coolant provided by the cooling tower is divided into two paths after passing through the circulating pump, and a coolant on one of the two paths is mixed with a coolant on the other path after passing through the compensatory refrigeration chiller, to obtain the mixed coolant.

5. The apparatus according to claim 4, wherein the circulating pump comprises a primary circulating pump and a secondary circulating pump, and the three-way valve comprises a first three-way valve and a second three-way valve; and
the integrated cooling source apparatus is specifically configured to:
when the compensatory refrigeration condition is triggered, adjust a status of the first three-way valve to a three-way state, so that the coolant from the cooling tower is divided into two paths after passing through the primary circulating pump, and a coolant on one of the two paths that passes through a condenser of the compensatory refrigeration chiller and a coolant on the other path that passes through a plate heat exchanger converge before the cooling tower; and adjust a status of the second three-way valve to a three-way state, so that the coolant passing through the plate heat exchanger is divided into two paths after passing through the secondary circulating pump, and a coolant on one of the two paths is mixed with a coolant on the other path after passing through an evaporator of the compensatory refrigeration chiller, to obtain the mixed coolant.

6. The apparatus according to claim 4 or 5, wherein the compensatory refrigeration condition comprises that a supply liquid temperature is greater than or equal to a preset threshold, the integrated cooling source apparatus further comprises a controller, and the controller is configured to:
when it is detected that the supply liquid temperature is greater than or equal to the preset threshold, control the status of the three-way valve to be the three-way state, and start the compensatory refrigeration chiller.

7. The apparatus according to claim 6, wherein the controller is specifically configured to:

   determine a bypass flow of the three-way valve based on the supply liquid temperature, a cooling temperature of the compensatory refrigeration chiller, a required temperature of the air-to-liquid heat exchange mode component, and a flow required for heat dissipation; and
   determine a valve opening proportion of the three-way valve based on the bypass flow, and adjust the status of the three-way valve to the three-way state based on the valve opening proportion.

8. The apparatus according to claim 6, wherein the controller is further configured to:
control a supply liquid temperature of the cooling tower based on a wet bulb temperature and an approach of the cooling tower, and then control a secondary-side temperature of the plate heat exchanger based on the supply liquid temperature and an approach of the plate heat exchanger.

9. The apparatus according to claim 6, wherein the controller is further configured to:
control a secondary-side temperature of the plate heat exchanger based on a wet bulb temperature, an approach of the cooling tower, and an approach of the plate heat exchanger.

10. The apparatus according to any one of claims 6 to 9, wherein the controller is further configured to:
detect that a temperature difference between a liquid outlet of the liquid-to-liquid heat exchange mode component and a liquid inlet of the air-to-liquid heat exchange mode component is less than a specified value, and reduce an opening of an electric valve deployed at the liquid inlet of the air-to-liquid heat exchange mode component.

11. The apparatus according to any one of claims 6 to 9, wherein the circulating pump comprises the primary circulating pump and the secondary circulating pump, the plate heat exchanger is disposed between the primary circulating pump and the secondary circulating pump, and the controller is further configured to:

   detect that a temperature difference between a primary-side liquid outlet and a primary-side liquid inlet of the plate heat exchanger is less than a specified value, and control the primary circulating pump to operate at a variable frequency; or
   detect that a temperature difference between a primary-side liquid outlet and a secondary-side liquid inlet of the plate heat exchanger is less than the approach of the plate heat exchanger, and control the primary circulating pump to operate at a variable frequency.

12. A heat dissipation system, wherein the heat dissipation system comprises the integrated cooling source apparatus according to any one of FIG. 1 to FIG. 10, an air-to-liquid heat exchange mode component, and a liquid-to-liquid heat exchange mode component, and the integrated cooling source apparatus is configured to collaborate with the air-to-liquid heat exchange mode component and the liquid-to-liquid heat exchange mode component to dissipate heat for a device.

13. A heat dissipation control method, applied to an integrated cooling source apparatus, wherein the integrated cooling source apparatus comprises a controller, a cooling tower, a circulating pump, a three-way valve, and a compensatory refrigeration chiller, the cooling tower is connected to the circulating pump through a liquid cooling pipeline, the circulating pump is connected to the compensatory refrigeration chiller through a liquid cooling pipeline, the three-way valve is deployed on the liquid cooling pipeline connecting the circulating pump and the compensatory refrigeration chiller, and the method comprises:

detecting, by the controller, a supply liquid temperature; and
when the supply liquid temperature is greater than or equal to a preset threshold, controlling, by the controller, a status of the three-way valve to be a three-way state, and starting the compensatory refrigeration chiller, so that a coolant from the cooling tower is divided into two paths after passing through the circulating pump, and a coolant on one of the two paths is mixed with a coolant on the other path after passing through the compensatory refrigeration chiller, to obtain a mixed coolant.

14. The method according to claim 13, wherein controlling, by the controller, the status of the three-way valve to be the three-way state comprises:

determining, by the controller, a bypass flow of the three-way valve based on the supply liquid temperature, a cooling temperature of the compensatory refrigeration chiller, a required temperature of the air-to-liquid heat exchange mode component, and a flow required for heat dissipation; and
determining, by the controller, a valve opening proportion of the three-way valve based on the bypass flow, and adjusting the status of the three-way valve to the three-way state based on the valve opening proportion.

15. The method according to claim 13, wherein the circulating pump comprises a primary circulating pump and a secondary circulating pump, a plate heat exchanger is disposed between the primary circulating pump and the secondary circulating pump, and the method further comprises:

controlling a supply liquid temperature of the cooling tower based on a wet bulb temperature and an approach of the cooling tower, and then controlling a secondary-side temperature of the plate heat exchanger based on the supply liquid temperature and an approach of the plate heat exchanger; or
controlling a secondary-side temperature of the plate heat exchanger based on a wet bulb temperature, an approach of the cooling tower, and an approach of the plate heat exchanger.

16. The method according to any one of claims 13 to 15, wherein the method further comprises:
detecting that a temperature difference between a liquid outlet of the liquid-to-liquid heat exchange mode component and a liquid inlet of the air-to-liquid heat exchange mode component is less than a specified value, and reducing an opening of an electric valve deployed at the liquid inlet of the air-to-liquid heat exchange mode component.

17. The method according to any one of claims 13 to 16, wherein the circulating pump comprises the primary circulating pump and the secondary circulating pump, the plate heat exchanger is disposed between the primary circulating pump and the secondary circulating pump, and the method further comprises:

detecting that a temperature difference between a primary-side liquid outlet and a primary-side liquid inlet of the plate heat exchanger is less than a specified value, and controlling the primary circulating pump to operate at a variable frequency; or
detecting that a temperature difference between a primary-side liquid outlet and a secondary-side liquid inlet of the plate heat exchanger is less than the approach of the plate heat exchanger, and controlling the primary circulating pump to operate at a variable frequency.

18. A controller, wherein the controller comprises a processor and an input/output unit, the input/output unit is configured to communicate with a three-way valve in an integrated cooling source apparatus, and the processor is configured to execute computer-readable instructions, to enable the controller to perform the heat dissipation control method according to any one of claims 13 to 16.

19. The controller according to claim 18, wherein the controller further comprises a memory, and the processor is specifically configured to load the computer-readable instructions from the memory and execute the computer-readable instructions.

FIG. 1

Liquid cooling equipment room

Exterior
wall of the
equipment
room

Liquid
cooling
door

Liquid
cooling
cabinet

Integrated
cooling source
apparatus

Liquid
cooling
plate heat
dissipation
control unit

FIG. 2

FIG. 3

FIG. 4

FIG. 5

FIG. 6

FIG. 7

FIG. 8

T2 (T)

324

Liquid cooling door

311

Liquid cooling cabinet

T1 (T)

V5

Liquid cooling plate heat dissipation control unit

326

FIG. 9

A controller 3221 detects a supply liquid temperature — S1002

The supply liquid temperature is greater than or equal to a preset threshold

The controller 3221 determines a bypass flow of a three-way valve 3224 based on the supply liquid temperature, a cooling temperature of a compensatory refrigeration chiller 3228, a required temperature of a liquid cooling door, and a flow required for heat dissipation — S1004

S1008

The controller 3221 starts a compensatory refrigeration chiller 3228, so that a coolant from a cooling tower 3222 is divided into two paths after passing through a circulating pump 3224, and a coolant on one of the two paths is mixed with a coolant on the other path after passing through the compensatory refrigeration chiller 3228, to obtain a mixed coolant

The controller 3221 determines a valve opening proportion of the three-way valve 3224 based on the bypass flow, and adjusts a status of the three-way valve 3224 to a three-way state based on the valve opening proportion — S1006

FIG. 10

**INTERNATIONAL SEAF**

| | International application No. |
|---|---|
| | **PCT/CN2024/087155** |

| **A.** | **CLASSIFICATION OF SUBJECT MATTER** |
|---|---|
| | H05K7/20(2006.01)i |

According to International Patent Classification (IPC) or to both national classification and IPC

| **B.** | **FIELDS SEARCHED** |
|---|---|

Minimum documentation searched (classification system followed by classification symbols)

IPC:H05K7/-

Documentation searched other than minimum documentation to the extent that such documents are included in the fields searched

Electronic data base consulted during the international search (name of data base and, where practicable, search terms used)

CNTXT, DWPI, CNABS, WPABS, WPABSC: 液冷, 风冷, 混合, 散热, 冷却液, 组合, 集成, 降温, 换热, 三通, liquid, cool+, wind, cold+, temperature, mix, combination, heat, exchange

| **C.** | **DOCUMENTS CONSIDERED TO BE RELEVANT** | | |
|---|---|---|---|
| Category* | Citation of document, with indication, where appropriate, of the relevant passages | | Relevant to claim No. |
| X | CN 114698329 A (XIAMEN HUARUISHENG INTELLIGENT TECHNOLOGY CO., LTD. et al.) 01 July 2022 (2022-07-01) description, paragraphs [0005]-[0054], and figures 1-2 | | 1-19 |
| A | CN 106679245 A (CHANGSHA MAXXOM HIGH-TECH CO., LTD.) 17 May 2017 (2017-05-17) entire document | | 1-19 |
| A | CN 106895526 A (GUANGDONG SHENLING ENVIRONMENTAL SYSTEMS CO., LTD.) 27 June 2017 (2017-06-27) entire document | | 1-19 |
| A | CN 106941772 A (GUANGDONG SHENLING ENVIRONMENTAL SYSTEMS CO., LTD.) 11 July 2017 (2017-07-11) entire document | | 1-19 |
| A | CN 107743354 A (BEIJING BAIDU NETCOM SCIENCE AND TECHNOLOGY CO., LTD.) 27 February 2018 (2018-02-27) entire document | | 1-19 |

☑ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **16 May 2024** | **21 May 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

# EP 4 730 934 A1

## INTERNATIONAL SEARCH REPORT

| International application No. |
|---|
| **PCT/CN2024/087155** |

### C. DOCUMENTS CONSIDERED TO BE RELEVANT

| Category* | Citation of document, with indication, where appropriate, of the relevant passages | Relevant to claim No. |
|---|---|---|
| A | CN 109831891 A (VERTIV TECHNOLOGY CO., LTD.) 31 May 2019 (2019-05-31) entire document | 1-19 |
| A | CN 112236022 A (SUZHOU INSPUR INTELLIGENT TECHNOLOGY CO., LTD.) 15 January 2021 (2021-01-15) entire document | 1-19 |
| A | CN 207652877 U (VERTIV TECHNOLOGY CO., LTD.) 24 July 2018 (2018-07-24) entire document | 1-19 |
| A | WO 2007069230 A2 (SFD LTD.) 21 June 2007 (2007-06-21) entire document | 1-19 |

Form PCT/ISA/210 (second sheet) (July 2022)

31

**INTERNATIONAL SEARCH REPORT**
Information on patent family members

International application No.

**PCT/CN2024/087155**

| Patent document cited in search report | | | Publication date (day/month/year) | Patent family member(s) | | | Publication date (day/month/year) |
|---|---|---|---|---|---|---|---|
| CN | 114698329 | A | 01 July 2022 | None | | | |
| CN | 106679245 | A | 17 May 2017 | None | | | |
| CN | 106895526 | A | 27 June 2017 | None | | | |
| CN | 106941772 | A | 11 July 2017 | None | | | |
| CN | 107743354 | A | 27 February 2018 | US | 2019124798 | A1 | 25 April 2019 |
| | | | | US | 10881031 | B2 | 29 December 2020 |
| CN | 109831891 | A | 31 May 2019 | None | | | |
| CN | 112236022 | A | 15 January 2021 | None | | | |
| CN | 207652877 | U | 24 July 2018 | None | | | |
| WO | 2007069230 | A2 | 21 June 2007 | None | | | |

Form PCT/ISA/210 (patent family annex) (July 2022)

**REFERENCES CITED IN THE DESCRIPTION**

**Patent documents cited in the description**

- CN 202310729682
- CN 2023109537247

- CN 202311724720